# FASCICULE DE BREVET EUROPEEN

(11) **EP 2 562 802 B1**
(45) Date de publication et mention de la délivrance du brevet: **08.01.2020**
(21) Numéro de dépôt: 12181068.3
(22) Date de dépôt: 20.08.2012
(51) Int. Cl.: H01L 27/06, H01L 21/84

(54) **Procede de realisation d'un circuit integre tridimensionnel**
Verfahren zur Herstellung eines dreidimensionalen integrierten Schaltkreises
Method for producing a three-dimensional integrated circuit

(30) Priorité: 25.08.2011 FR 1157531
(43) Date de publication de la demande: 27.02.2013
(73) Titulaire: Commissariat à l'Énergie Atomique et aux Énergies Alternatives, 75015 Paris (FR)
(72) Inventeur: Previtali, Bernard, 38100 GRENOBLE (FR)
(74) Mandataire: Ilgart, Jean-Christophe

(56) Documents cités:
- US-A1- 2004 065 884
- US-A1- 2007 145 367
- US-A1- 2008 054 359
- US-A1- 2009 020 817

## Description

### DOMAINE TECHNIQUE

La présente invention concerne un procédé de réalisation d'un circuit électronique intégré tridimensionnel, par exemple de type CMOS, pouvant comporter des dispositifs MOS réalisés à partir de matériaux semi-conducteurs par exemple monocristallins.

L'invention s'applique notamment à la réalisation d'un circuit intégré comportant des transistors MOS ou des cellules mémoires de type Flash.

### ÉTAT DE LA TECHNIQUE ANTÉRIEURE

Par rapport à un circuit intégré classique réalisé à partir d'une unique couche de semi-conducteur, un circuit intégré tridimensionnel, c'est-à-dire comportant plusieurs niveaux superposés de dispositifs électroniques tels que des transistors MOS, permet d'augmenter la densité d'intégration des dispositifs électroniques au sein du circuit intégré et également de réduire les temps de propagation moyens des signaux dans les interconnexions électriques reliées aux composants électroniques.

Un tel circuit intégré tridimensionnel peut être obtenu par une intégration parallèle des différents niveaux. Une telle intégration parallèle consiste à réaliser en parallèle et séparément les différents niveaux du circuit intégré à partir de différents substrats, puis à les coller les uns au-dessus des autres. Le collage entre les substrats peut être mis en œuvre après avoir réalisé une siliciuration des zones actives des transistors, ou bien après avoir réalisé des premiers niveaux d'interconnexions électriques sur chacun des substrats. Des interconnexions électriques communes aux différents substrats sont réalisées après le collage des substrats entre eux.

Le document US 6 624 046 B1 décrit un circuit intégré tridimensionnel obtenu par la mise en œuvre d'une telle intégration parallèle. Plusieurs circuits sont fabriqués séparément à partir de différents substrats, puis empilés et interconnectés entre eux par des interconnexions électriques verticales. Chaque nouvelle couche de circuit est reportée sur l'empilement de circuits préalablement réalisé et des trous sont formés à travers la nouvelle couche de circuit, en regard de zones de contacts électriques préalablement définies sur l'empilement. Un matériau électriquement conducteur est alors déposé dans ces trous afin de réaliser les interconnexions électriques entre cette nouvelle couche de circuit et le reste de l'empilement.

Lors d'une telle intégration parallèle, on effectue donc le report d'un deuxième substrat comprenant des composants électroniques, réalisés par un certain nombre de niveaux de lithographie, sur un premier substrat comprenant également des composants électroniques réalisés par plusieurs niveaux de lithographie. L'étape de collage des deux substrats doit donc être réalisée en alignant ces deux substrats l'un par rapport à l'autre afin que les motifs (dispositifs électroniques, zones de contact électrique, ...) définis sur le deuxième substrat soient convenablement positionnés par rapport aux motifs définis sur le premier substrat. Or, les performances actuelles d'alignement lors d'un tel collage sont limitées à quelques microns, ce qui exclut la possibilité de faire appel à une telle intégration parallèle pour réaliser par exemple des interconnexions électriques locales dans des zones denses du circuit.

La densité d'intégration des dispositifs électroniques dans le circuit intégré pouvant être atteinte avec une telle approche est donc limitée.

US2004065884 défini la construction de transistors CMOS en 3D à base de couches minces successivement superposées.

Une solution à ces problèmes d'alignement consiste à réaliser le circuit intégré par une intégration séquentielle des différents niveaux de composants électroniques du circuit intégré. Les différents niveaux de dispositifs électroniques sont dans ce cas réalisés les uns après les autres. Un premier niveau de transistors est par exemple obtenu de manière classique à partir d'un premier substrat de type Bulk ou SOI (Silicium sur isolant). Un deuxième niveau de transistors est réalisé à partir d'une couche de matériau semi-conducteur qui est soit reportée sur le premier niveau de transistors (comme décrit dans les documents FR 2 896 620 et US 2008/0054359 A1), soit obtenue par une épitaxie (ou un dépôt polycristallin recristallisé) réalisée via des ouvertures formées à travers un matériau diélectrique protégeant le premier niveau de transistors (comme décrit dans les documents US 4 472 729 ou US 2009/0020817 A1).

Dans le document FR 2 896 620, le circuit intégré comporte une superposition de transistors PMOS sur des transistors NMOS obtenue en reportant une couche de Germanium sur un matériau diélectrique planarisé recouvrant les transistors NMOS qui sont réalisés à partir d'un substrat de Silicium. Les transistors PMOS sont ensuite réalisés dans la couche de Germanium. Le couplage capacitif entre les deux niveaux de transistors est ici dépendant de l'uniformité de la planarisation du matériau diélectrique. L'épaisseur du diélectrique à graver lors de la réalisation des contacts électriques est environ 2 fois plus importante pour le niveau inférieur que pour le niveau supérieur. Or, ceci peut entraîner une dégradation des zones de contacts électriques du niveau supérieur ou une insuffisance de gravure pour le niveau inférieur. Une solution consiste à réaliser les contacts électriques en plusieurs étapes, ce qui augmente en contrepartie les coûts de réalisation.

Lors de la réalisation d'un circuit intégré par intégration séquentielle, le ou les niveaux supérieurs de dispositifs électroniques doivent être réalisés en mettant en jeu des budgets thermiques réduits afin de ne pas dégrader le ou les niveaux inférieurs de dispositifs électroniques.

Ces différentes intégrations de plusieurs niveaux de transistors se heurtent également à la congestion des niveaux d'interconnexions électriques réalisés.

### EXPOSÉ DE L'INVENTION

Un but de la présente invention est de proposer un nouveau type de procédé de réalisation de circuit intégré permettant de réaliser un circuit intégré tridimensionnel ne présentant pas les problèmes d'alignement, de budgets thermiques à respecter et de gravure de diélectrique lors de la réalisation des niveaux d'interconnexions électriques du circuit intégré, et qui permette de s'affranchir des problèmes de congestion des niveaux d'interconnexions électriques rencontrés lors de la mise en œuvre des procédés de réalisation de circuit intégré de l'art antérieur.

Pour cela, la présente invention propose un procédé de réalisation d'un circuit électronique intégré comportant au moins les étapes de :
- réalisation d'un substrat comportant au moins une première et une deuxième couches de semi-conducteur entre lesquelles est disposée au moins une troisième couche de matériau,
- réalisation d'au moins un premier dispositif MOS dont une zone active est formée dans au moins une partie de la première couche de semi-conducteur,
- réalisation d'au moins un deuxième dispositif MOS dont une zone active est formée dans au moins une partie de la deuxième couche de semi-conducteur, la zone active du deuxième dispositif MOS étant disposée entre une grille du deuxième dispositif MOS et la zone active du premier dispositif MOS.

L'invention propose un procédé de réalisation d'un circuit électronique intégré comportant au moins les étapes de :
- réalisation d'un substrat comportant au moins une première et une deuxième couches de semi-conducteur entre lesquelles est disposée au moins une troisième couche de matériau, puis
- réalisation d'au moins un premier dispositif MOS dont une zone active est formée dans au moins une partie de la première couche de semi-conducteur, puis
- réalisation d'au moins un deuxième dispositif MOS dont une zone active est formée dans au moins une partie de la deuxième couche de semi-conducteur, la zone active du deuxième dispositif MOS étant disposée entre une grille du deuxième dispositif MOS et la zone active du premier dispositif MOS.

Selon l'invention, au moins deux niveaux de dispositifs MOS sont réalisés de chaque côté d'un substrat comportant au moins deux couches de semi-conducteur servant à réaliser les zones actives (correspondant à la source, au drain et au canal pour un transistor MOS) des dispositifs MOS.

Un tel procédé permet donc de s'affranchir des problèmes d'alignement rencontrés lors d'une intégration parallèle des différents niveaux de dispositifs, par exemple lorsque des dispositifs MOS sont réalisés indépendamment les uns des autres puis reliés électriquement les uns aux autres, ou bien lorsqu'un premier dispositif MOS est réalisé dans un substrat puis un deuxième dispositif MOS est réalisé au-dessus du premier dispositif MOS. De plus, étant donné que les deux niveaux de dispositifs MOS sont réalisés de part et d'autre du substrat, les interconnexions électriques peuvent également être réalisées de part et d'autre du substrat ce qui résout les problèmes liés à l'épaisseur de matériau à graver pour réaliser ces interconnexions électriques et ceux liés à la congestion des niveaux d'interconnexions électriques.

Enfin, bien qu'étant de type séquentiel, ce procédé permet de réaliser chaque niveau de dispositifs MOS avec des caractéristiques proche des circuits intégrés non tridimensionnels en terme de budget thermique.

La distance entre les zones actives des deux dispositifs MOS, c'est-à-dire le couplage entre ces deux dispositifs MOS, est choisie par l'intermédiaire de l'épaisseur choisie de la troisième couche.

La zone active du deuxième dispositif MOS est disposée entre une grille du deuxième dispositif MOS et la zone active du premier dispositif MOS, en considérant que ces éléments sont disposés le long d'un même axe.

Bien que le procédé soit décrit ici comme réalisant deux dispositifs MOS, le procédé sera avantageusement mis en œuvre pour réaliser un premier niveau de dispositifs MOS comportant plusieurs premiers dispositifs MOS et un deuxième niveau de dispositifs MOS comportant plusieurs deuxièmes dispositifs MOS.

Le premier et le deuxième dispositifs MOS peuvent être de conductivité complémentaire, l'un étant de type NMOS et l'autre de type PMOS.

Les matériaux de la première et de la deuxième couche de semi-conducteur peuvent être monocristallins. Ainsi, les dispositifs MOS peuvent présenter de très bonnes performances électriques et une faible consommation électrique.

La première couche de semi-conducteur, la deuxième couche de semi-conducteur et la troisième couche de matériau peuvent être à base de semi-conducteurs monocristallins réalisés par épitaxie. Dans une telle configuration, les matériaux de ces trois couches présentent alors une même orientation cristalline. De plus, l'épaisseur de chacune de ces couches est alors parfaitement contrôlée, contrairement aux procédés de l'art antérieur comportant des étapes de dépôt et de planarisation mécano-chimique qui engendrent des problèmes d'uniformité, et donc des couplages capacitifs non contrôlables au sein des dispositifs réalisés.

Dans une autre variante, ces trois couches peuvent être composées de matériaux semi-conducteurs polycristallins. Une telle variante peut notamment être envisagée pour la réalisation de transistors de type TFT (transistors couches minces).

La troisième couche peut être composée au moins de SiGe ou de silicium poreux.

Dans une variante, il est possible que la troisième couche soit composée d'un matériau diélectrique, par exemple du dioxyde de silicium. Cette troisième couche peut dans ce cas être le résultat d'un collage moléculaire de deux couches diélectriques.

Lors de la réalisation du premier dispositif MOS, la première couche de semi-conducteur et la troisième couche peuvent être gravées selon un même motif correspondant à la zone active du premier dispositif MOS.

Lors de la réalisation du premier dispositif MOS, la première et la deuxième couches de semi-conducteur et la troisième couche peuvent être gravées selon un même motif correspondant aux zones actives du premier et du deuxième dispositifs MOS. Ainsi, le premier et le deuxième transistor comportent des zones actives auto-alignées.

Le procédé peut comporter en outre, lors de la réalisation du deuxième dispositif MOS, la mise en œuvre des étapes de :
- retrait d'une portion restante de la troisième couche gravée selon le motif correspondant à la zone active du premier dispositif MOS,
- dépôt d'un matériau diélectrique au moins entre les zones actives du premier et du deuxième dispositifs MOS.

La troisième couche sert dans ce cas de matériau sacrificiel qui peut être gravé sélectivement par rapport à un matériau diélectrique formant par exemple des isolations latérales des dispositifs MOS et qui entoure ce matériau sacrificiel.

En retirant la portion restante de la troisième couche, on obtient une cavité disposée entres les deux canaux des deux dispositifs MOS. Il est possible de disposer dans cette cavité du matériau diélectrique (high K ou non), ou bien une grille flottante (par exemple composée de diélectrique high K et de TiN pouvant être déposés par CVD), ou un empilement ONO (oxyde-nitrure-oxyde) formant ainsi une mémoire flash et/ou permettant de réaliser une modulation des tensions de seuil des dispositifs MOS

Le procédé peut comporter en outre, lors de la réalisation du deuxième dispositif MOS, la mise en œuvre des étapes de :
- retrait d'une portion restante de la troisième couche gravée selon le motif correspondant à la zone active du premier dispositif MOS,
- réalisation, entre les zones actives du premier et du deuxième dispositifs MOS, d'un empilement comportant une portion de matériau électriquement conducteur disposée entre deux portions de matériau diélectrique.

On peut réaliser ainsi un premier et un deuxième dispositifs MOS superposés et comportant une électrode formant une grille flottante permettant de réaliser une commande arrière de ces deux dispositifs MOS. Une telle portion de matériau électriquement conducteur peut permettre également de bloquer localement le couplage capacitif entre les deux dispositifs MOS.

Les dispositifs MOS peuvent être des transistors.

Le procédé peut comporter en outre, lors de la réalisation du deuxième dispositif MOS, la mise en œuvre des étapes de :
- retrait d'une portion restante de la troisième couche gravée selon le motif correspondant à la zone active du premier dispositif MOS,
- réalisation, entre les zones actives du premier et du deuxième dispositifs MOS, d'un empilement mémoire comportant une portion de matériau apte à réaliser une rétention de charges électriques disposée entre deux portions de matériau diélectrique,
les premier et deuxième dispositifs MOS pouvant former une cellule mémoire.

La cellule mémoire peut être dans ce cas de type Flash.

Le procédé peut comporter en outre, entre les étapes de réalisation du premier et du deuxième dispositifs MOS, les étapes de :
- dépôt d'un matériau diélectrique recouvrant au moins le premier dispositif MOS,
- solidarisation dudit matériau diélectrique contre un deuxième substrat.

La solidarisation du matériau diélectrique au deuxième substrat est avantageusement réalisée après une activation thermique de dopants implantés dans la zone active du premier transistor.

Le procédé peut comporter en outre, après la réalisation du deuxième dispositif MOS, les étapes de :
- dépôt d'un matériau diélectrique recouvrant le deuxième dispositif MOS,
- réalisation, au moins dans le matériau diélectrique recouvrant le deuxième dispositif MOS, d'au moins un premier niveau d'interconnexions électriques et un ou plusieurs vias reliant électriquement le deuxième dispositif MOS au premier niveau d'interconnexions électriques, le deuxième dispositif MOS étant disposé entre le premier niveau d'interconnexions électriques et le premier dispositif MOS.

Le terme « vias » désigne des connexions électriques verticales reliant par exemple le dispositif MOS avec un niveau d'interconnexions électriques ou deux niveaux d'interconnexions électriques. On réalise ici un ou plusieurs premiers niveaux d'interconnexions électriques, c'est-à-dire un ou plusieurs niveaux d'interconnexions électriques superposés et disposés au-dessus du deuxième transistor.

Le procédé peut comporter en outre, après la réalisation du premier niveau d'interconnexions électriques, les étapes de :
- solidarisation du matériau diélectrique recouvrant le deuxième dispositif MOS contre un troisième substrat,
- retrait du deuxième substrat,
- réalisation, au moins dans un matériau diélectrique recouvrant le premier dispositif MOS, d'au moins un deuxième niveau d'interconnexions électriques et un ou plusieurs vias reliant électriquement le premier dispositif MOS au deuxième niveau d'interconnexions électriques, le premier dispositif MOS étant disposé entre le deuxième niveau d'interconnexions électriques et le deuxième dispositif MOS.

On réalise ici un ou plusieurs deuxièmes niveaux d'interconnexions électriques, c'est-à-dire un ou plusieurs niveaux d'interconnexions électriques superposés et disposés au-dessus du premier transistor.

Les niveaux d'interconnexions électriques reliés électriquement au premier et au deuxième dispositifs MOS sont réalisés après avoir formé les zones actives des deux dispositifs MOS. Ainsi, les budgets thermiques mis en jeu pour réaliser les deux dispositifs MOS ne sont pas limités en raison de la présence de ces interconnexions.

Il est possible de réaliser les niveaux d'interconnexions électriques reliés électriquement au premier dispositif MOS avant de réaliser le report sur le deuxième substrat. Dans ce cas, le budget thermique lors de la réalisation du deuxième dispositif MOS est limité, par exemple inférieur à environ 500°C.

Il est également possible de réaliser simultanément les niveaux d'interconnexions électriques reliés électriquement au premier et au deuxième dispositifs MOS.

Il est également possible de réaliser une partie des niveaux d'interconnexions électriques reliés électriquement au premier dispositif MOS avant de réaliser le report sur le premier substrat. Cette partie des niveaux d'interconnexions électriques reliés électriquement au premier dispositif MOS peut consister à réaliser une siliciuration des zones à contacter, puis à réaliser des contacts électriques reliés aux zones siliciurées. Le niveau « métal 1 » est remplacé par un dépôt de matériau pouvant être gravé sélectivement (par exemple du Si₃N₄) par rapport au matériau (par exemple du SiO₂) destiné à entourer les niveaux d'interconnexions électriques. Lors de la réalisation des interconnexions du deuxième niveau (« métal 2 »), des vias suffisamment larges peuvent être réalisés pour supprimer le matériau gravable sélectivement et le remplacer par un matériau électriquement conducteur tel que du cuivre. Une telle configuration peut être réalisée lorsqu'un seul niveau d'interconnexions électriques est relié électriquement au premier dispositif MOS.

Le retrait du deuxième substrat permet d'accéder au premier dispositif MOS afin de le terminer, en réalisant par exemple une siliciuration des régions de source et de drain du premier dispositif MOS. Ainsi, ces zones siliciurées ne limitent pas les budgets thermiques mis en jeu pour réaliser les deux dispositifs MOS.

La troisième couche peut comporter des régions d'épaisseurs différentes telles que, lorsque le procédé comporte la réalisation de plusieurs premiers dispositifs MOS et de plusieurs deuxièmes dispositifs MOS, les distances entre les zones actives d'un premier et d'un deuxième dispositifs MOS réalisés l'un au-dessus de l'autre peuvent correspondre aux différentes épaisseurs de la troisième couche. On peut ainsi réaliser un circuit intégré comportant des dispositifs MOS couplés différemment entre eux. Il est notamment possible de moduler les tensions de seuil des différents dispositifs MOS suivant les applications envisagées. Ainsi, en réduisant les tensions de seuil, il est possible de réaliser un circuit électronique intégré adapté à des applications demandant peu de puissance, ou au contraire en augmentant les tensions de seuil, réaliser un circuit électronique intégré adapté à des applications de plus forte puissance.

La troisième couche qui comporte des régions d'épaisseurs différentes peut être obtenue en réalisant plusieurs étapes successives d'épitaxie du matériau de la troisième couche sur la deuxième couche de semi-conducteur au cours desquelles des masques sont réalisés sur les couches épitaxiées afin de former les régions d'épaisseurs différentes de la troisième couche.

Lorsque le premier et/ou le deuxième dispositif MOS est de type PMOS, la réalisation du premier et/ou du deuxième dispositif PMOS peut comporter la mise en œuvre d'une épitaxie de SiGe sur la partie de la première et/ou de la deuxième couche de semi-conducteur destinée à former la zone active du premier et/ou du deuxième dispositif PMOS.

Lorsque le premier dispositif MOS est de type PMOS, la réalisation du premier dispositif PMOS comporte la mise en œuvre d'une épitaxie de SiGe sur la partie de la première couche de semi-conducteur destinée à former la zone active du premier dispositif PMOS, et/ou, lorsque le deuxième dispositif MOS est de type PMOS, la réalisation du deuxième dispositif PMOS comporte la mise en œuvre d'une épitaxie de SiGe sur la partie de la deuxième couche de semi-conducteur destinée à former la zone active du deuxième dispositif PMOS.

Ainsi, la couche active servant à la réalisation du dispositif PMOS peut être composée d'un bicouche Si-SiGe permettant d'optimiser la mobilité des trous dans le dispositif PMOS.

On peut envisager de coupler le circuit intégré obtenu avec un ou plusieurs autres circuits intégrés selon le nombre de niveaux de circuits souhaité.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 14B représentent les étapes d'un procédé de réalisation d'un circuit électronique intégré, objet de la présente invention, selon un premier mode de réalisation,
- les figures 15A à 15G représentent une partie des étapes d'un procédé de réalisation d'un circuit électronique intégré, objet de la présente invention, selon un deuxième mode de réalisation,
- les figures 16A à 16D représentent une partie des étapes d'un procédé de réalisation d'un circuit électronique intégré, objet de la présente invention, selon un troisième mode de réalisation,
- les figures 17A à 17E représentent une partie des étapes d'un procédé de réalisation d'un circuit électronique intégré, objet de la présente invention, selon un quatrième mode de réalisation,
- les figures 18A à 18E représentent une partie des étapes d'un procédé de réalisation d'un circuit électronique intégré, objet de la présente invention, selon un cinquième mode de réalisation,
- les figures 19A à 19D représentent une partie des étapes d'un procédé de réalisation d'un circuit électronique intégré, objet de la présente invention, selon un sixième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

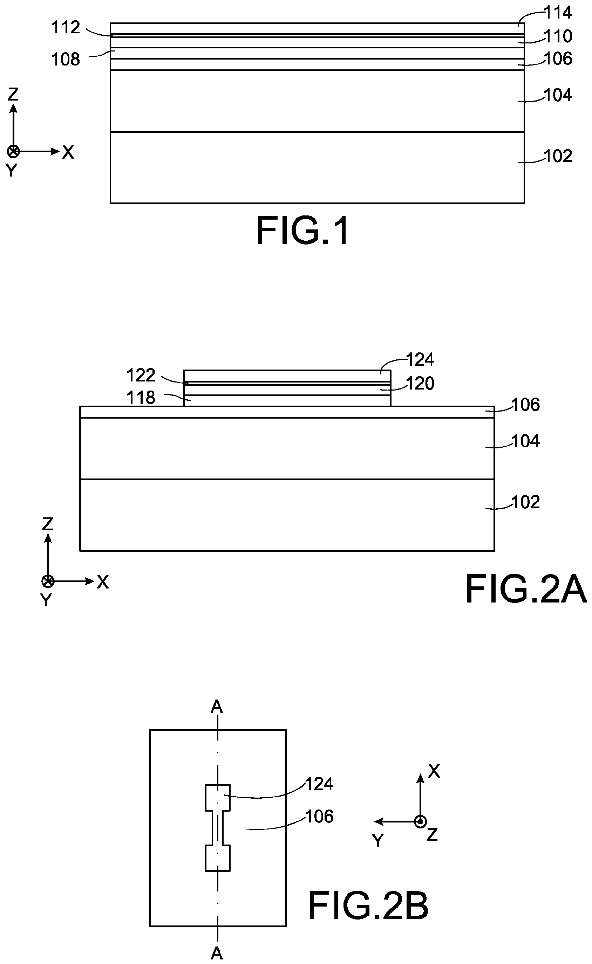

On se réfère tout d'abord aux figures 1 à 14B qui représentent les étapes d'un procédé de réalisation d'un circuit intégré 100, objet de la présente invention, selon un premier mode de réalisation. Bien que la réalisation de seulement deux dispositifs MOS 140 et 172, ici des transistors, répartis sur deux niveaux différents du circuit intégré 100 soit représentée sur ces figures, le procédé mis en œuvre permet de réaliser un circuit intégré 100 comportant une pluralité de premiers dispositifs MOS et une pluralité de deuxièmes dispositifs MOS répartis sur deux niveaux différents du circuit intégré 100.

Comme représenté sur la figure 1, le procédé est mis en œuvre à partir d'un substrat de type semi-conducteur sur isolant, par exemple SOI, comprenant une couche support de semi-conducteur 102, par exemple composée de silicium, sur laquelle est disposée une couche diélectrique enterrée 104, par exemple composée de SiO₂, et une couche superficielle de semi-conducteur 106, par exemple une couche mince de silicium d'épaisseur inférieure à environ 10 µm, et de préférence inférieure à environ 100 nm. On forme par exemple par épitaxie, sur la couche superficielle de silicium 106, une couche sacrificielle 108 composée par exemple de SiGe puis, sur la couche sacrificielle 108, une autre couche de semi-conducteur 110, par exemple composée de silicium et formée par exemple par épitaxie. La couche 110 est appelée par la suite première couche de semi-conducteur et la couche 106 est appelée deuxième couche de semi-conducteur. La couche sacrificielle 108 forme une troisième couche disposée entre la première et la deuxième couche de semi-conducteur 108, 110.

La couche sacrificielle 108 de SiGe a par exemple une épaisseur comprise entre environ 2 nm et 100 nm. De plus, la couche sacrificielle 108 peut être composée d'environ 10% à 60% de germanium, par exemple 20% de Germanium. La concentration en germanium de la couche sacrificielle 108 est choisie notamment en fonction de l'épaisseur souhaitée de la première couche de semi-conducteur 110, qui est par exemple comprise entre environ 2 nm et 100 nm, étant donné que l'épaisseur de silicium qu'il est possible de faire croître par épitaxie sans relaxation est notamment fonction de la concentration en germanium du matériau de la couche sacrificielle 108. Le document "Chemical vapour etching of Si, SiGe and Ge with HCl; applications to the formation of thin relaxed SiGe buffers and to the revelation of threading dislocations" de Y. Bogumilowicz et al., Semicond. Science & Technology, (20) 2005, pages 127-134, décrit plus en détail la relation entre la concentration en germanium d'une couche de SiGe et l'épaisseur de Silicium pouvant être obtenue par épitaxie sur la couche de SiGe.

Les couches 106 et 110 sont composées de semi-conducteur du fait que ces deux couches servent à la réalisation ultérieure des zones actives des transistors MOS du circuit intégré 100. Le SiGe de la couche sacrificielle 108 a également pour avantage de pouvoir être gravé sélectivement par rapport au silicium des couches de semi-conducteur 106 et 110. La concentration en germanium de la couche sacrificielle 108 va également influer sur la sélectivité de gravure du SiGe par rapport au silicium des couches 106 et 110.

Toutefois, il est possible que la couche 106 et/ou la couche 110 soit également composées de SiGe, ou que la couche 108 soit composée d'un matériau ne pouvant pas être gravé sélectivement par rapport au matériau semi-conducteur des couches 106 et 110. Dans ce cas, la suppression de la couche de matériau sacrificiel 108 qui sera réalisée ultérieurement au cours du procédé pourra être réalisée avec l'aide d'un masque ou d'une protection des couches 106 et 110.

Avantageusement, les trois couches 106, 108 et 110 sont composées de matériaux monocristallins. On obtient ainsi un empilement monocristallin Si-SiGe-Si.

Dans une variante de réalisation, la couche sacrificielle 108 peut être composée de silicium poreux.

Une couche d'oxyde 112, par exemple composée de SiO₂ et d'épaisseur comprise entre environ 5 nm et 30 nm, est formée par exemple par dépôt sur la première couche de semi-conducteur 110. Une couche de nitrure 114, par exemple composée de nitrure de silicium, et d'épaisseur comprise entre environ 10 nm et 50 nm, est formée par exemple par dépôt sur la couche d'oxyde 112.

Comme représenté sur les figures 2A et 2B (la figure 2A représentant une vue en coupe selon l'axe AA représenté sur la figure 2B ; la figure 2B représentant une vue de dessus), on réalise des étapes de photolithographie et gravure des couches 108, 110, 112 et 114 selon un motif définissant une zone active d'un premier transistor MOS 140, cette zone active étant destinée à être réalisée à partir d'une portion de silicium 120 correspondant à une portion restante de la première couche de semi-conducteur 110. La gravure est arrêtée sur la deuxième couche de semi-conducteur 106. Le motif formé par les portions restantes 118, 120, 122 et 124 des couches 108, 110, 112 et 114 correspondent aux futures régions de source, drain et canal du premier transistor MOS 140.

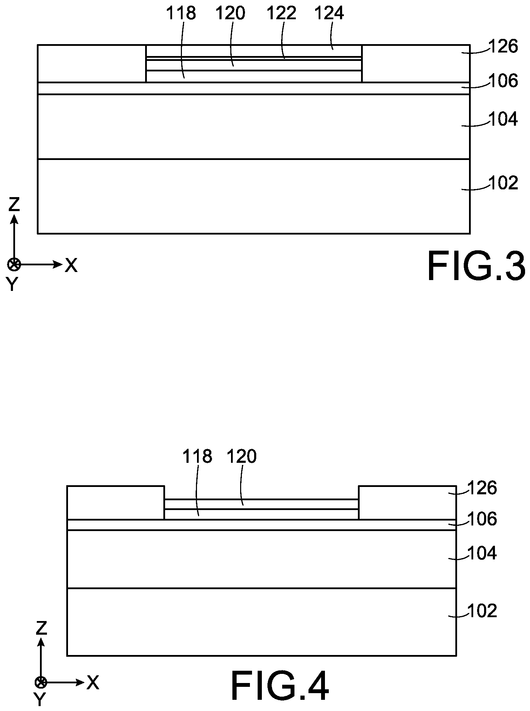

Un matériau diélectrique, par exemple du SiO₂, est ensuite disposé autour des portions restantes 118, 120, 122 et 124, formant des portions diélectriques 126 isolant latéralement (correspondant aux STI, ou « Shallow Trench Isolation ») la future zone active du premier transistor MOS (figure 3). Ces portions diélectriques 126 sont par exemple obtenues par la mise en œuvre d'un dépôt d'oxyde recouvrant l'empilement des portions restantes 118, 120, 122 et 124 ainsi que la deuxième couche de semi-conducteur 106, puis d'une planarisation mécano-chimique de cet oxyde avec arrêt sur la portion restante de nitrure 124. Outre leur rôle d'isolation électrique latérale, ces portions diélectriques 126 protègent également la deuxième couche de semi-conducteur 106, notamment lors des étapes de gravure de grille qui seront mises en œuvre ultérieurement. Les portions diélectriques 126 peuvent avoir une épaisseur, correspondant à la somme des épaisseurs des couches 108, 110, 112 et 114, comprise entre environ 20 nm et 100 nm.

Comme représenté sur la figure 4, on supprime les portions restantes 122 et 124 d'oxyde et de nitrure, révélant la portion restante 120 de silicium destinée à former la zone active du premier transistor MOS 140.

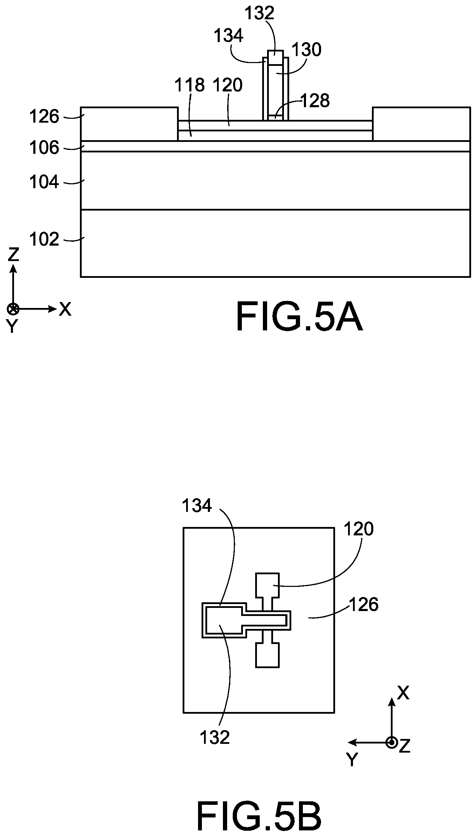

Comme représenté sur les figures 5A et 5B, on réalise une grille du premier transistor MOS 140. On dépose tout d'abord un diélectrique de grille 128 (par exemple du SiO₂, du HfO₂, du HfSiON, etc.), puis un matériau de grille 130 (par exemple du polysilicium) et enfin un masque dur 132, ces matériaux étant ensuite mis en forme par lithographie et gravure selon le motif de grille souhaité. Un espaceur de grille 134 est ensuite réalisé autour de la grille précédemment réalisée, le silicium de la portion 120 servant de couche d'arrêt de gravure lors de la réalisation de l'espaceur de grille 134. Des dopants sont ensuite implantés dans les parties de la portion restante de silicium 120 non recouvertes par la grille afin de former les zones de LDD (« Light Doped Drain ») et LDS (« Light Doped Source ») du premier transistor MOS 140.

Les dopants sont de type N ou P selon le type du premier transistor MOS 140 (par exemple PMOS).

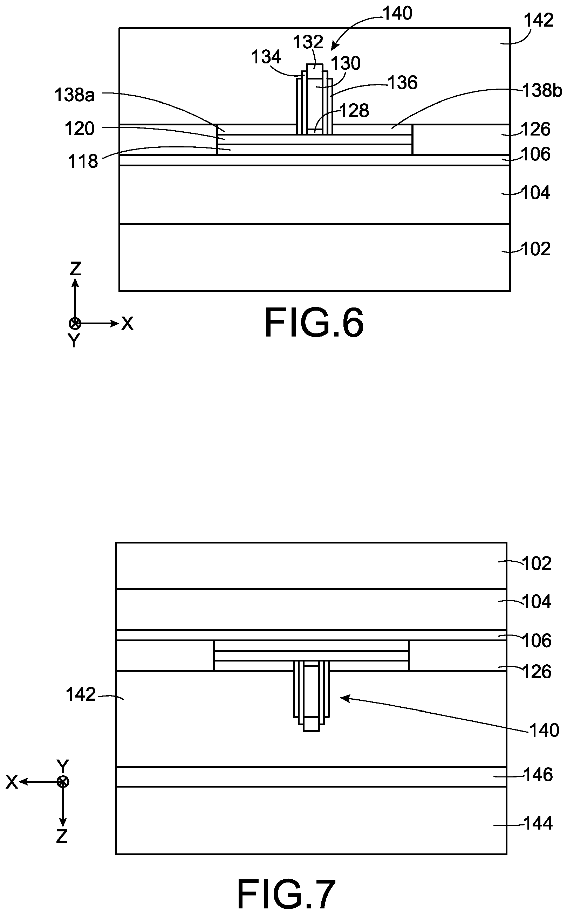

Comme représenté sur la figure 6, un deuxième espaceur de grille 136 est réalisé autour du premier espaceur 134. Là encore, le silicium de la portion 120 sert de couche d'arrêt de gravure lors de la réalisation du deuxième espaceur de grille 136. En variante, il est possible qu'un seul espaceur de grille soit réalisé autour de la grille.

On réalise ensuite les régions de source 138a et drain 138b du premier transistor MOS 140, par exemple par épitaxie de silicium dopé in situ ou par implantation de dopants dans les parties de la portion 120 non recouvertes par la grille. Un recuit activant les dopants des régions de source 138a et de drain 138b est ensuite réalisé. Il est possible que ce recuit d'activation de dopants ne soit réalisé qu'ultérieurement, après la réalisation des deux transistors, afin d'activer, en une seule étape, les dopants des deux transistors MOS.

On réalisera de préférence une siliciuration des zones de source 138a et de drain 138b ultérieurement, après avoir réalisé le deuxième transistor MOS 172, afin de ne pas limiter le budget thermique des étapes mises en œuvre pour réaliser le deuxième transistor MOS 172.

L'ensemble précédemment réalisé (premier transistor MOS 140 + portions diélectriques 126) est alors recouvert d'un matériau diélectrique 142, par exemple de l'oxyde tel que du SiO₂, qui est déposé puis planarisé, par exemple en mettant en œuvre une CMP (planarisation mécano-chimique). Il est également possible que l'ensemble précédemment réalisé soit recouvert par plusieurs matériaux diélectriques (par exemple oxyde et/ou nitrure de semi-conducteur) intégrant éventuellement une couche d'arrêt de gravure qui sera utilisée pour arrêter une gravure ultérieure lors de la réalisation de contacts électriques.

L'ensemble obtenu est alors retourné et le matériau diélectrique 142 est solidarisé à un deuxième substrat 144 composé de silicium et comportant sur une face, du côté du matériau diélectrique 142, une couche d'oxyde 146 composée par exemple de SiO₂. Un collage est alors réalisé entre le matériau diélectrique 142 et la couche d'oxyde 146 (figure 7). Préalablement à cette solidarisation, il est possible de réaliser des marques permettant d'aligner les lithographies mises en œuvre ultérieurement, comme décrit dans le document FR 2 848 725.

La couche support de silicium 102 et la couche diélectrique enterrée 104 sont éliminées par exemple par abrasion mécanique partielle (supprimant une grande partie de la couche support 102), puis par gravure chimique du silicium sélective vis-à-vis du diélectrique de la couche 104 (par exemple à l'aide d'une solution de TMAH) et enfin par gravure chimique de la couche diélectrique enterrée 104 avec arrêt sur la deuxième couche de semi-conducteur 106.

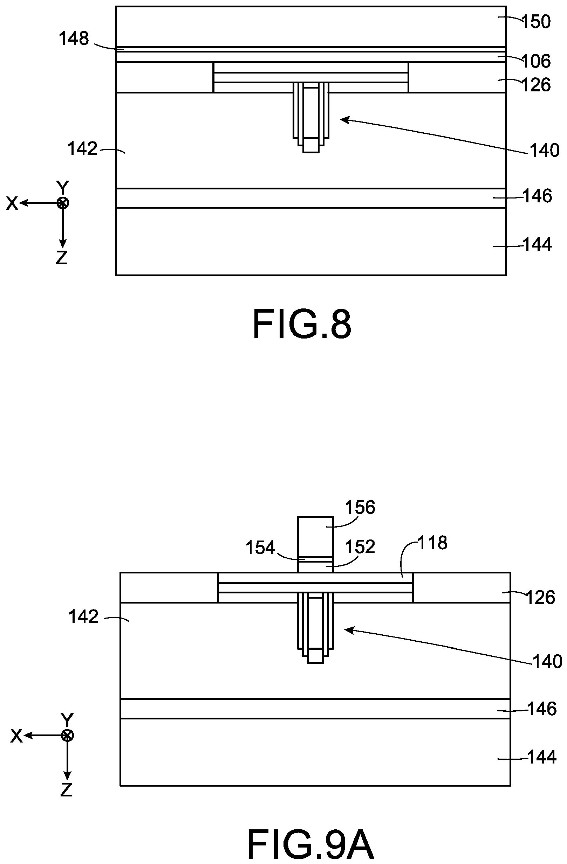

Comme représenté sur la figure 8, la deuxième couche de semi-conducteur 106 est recouverte d'une couche d'oxyde 148 et d'une couche de nitrure 150, par exemple similaires aux couches 112 et 114.

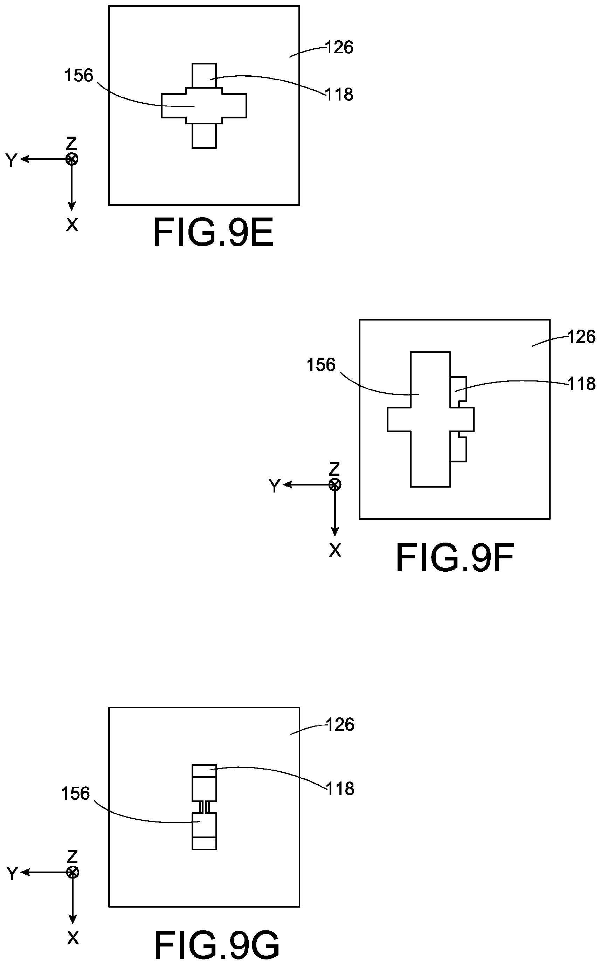

Les couches 106, 148 et 150 sont ensuite gravées selon un motif correspondant à celui de la zone active du deuxième transistor MOS 172. Cette gravure est arrêtée sur la portion restante de SiGe 118 et sur les portions diélectriques 126. On obtient des portions restantes 152, 154 et 156 de ces couches dont le motif correspond à celui de la zone active du deuxième transistor MOS 172 (voir figure 9A).

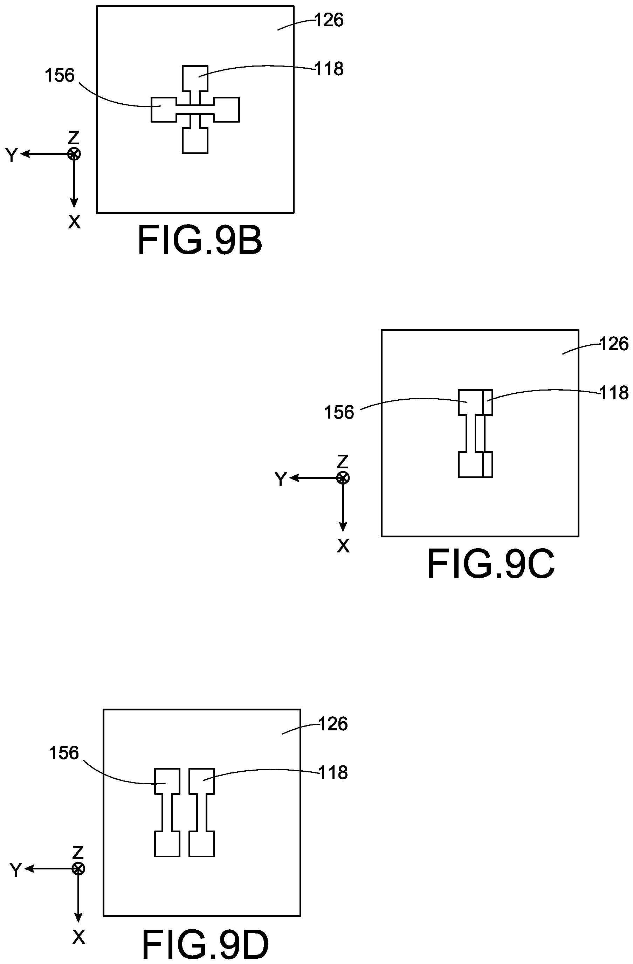

Les figures 9B à 9G représentent différents exemples du motif de la portion 156, qui correspond au motif de la zone active du deuxième transistor MOS 172.

Le motif de la portion de SiGe 118 représentée sur ces figures correspond au motif de la zone active du premier transistor MOS 140. Sur le premier exemple représenté sur la figure 9B, les zones actives des deux transistors MOS ont des dimensions sensiblement similaires. Etant donné que la portion restante de SiGe 118 est destinée à être gravée, le motif des portions restantes 152, 154 et 156 peut être tel qu'au moins une partie de la portion restante de SiGe 118 est accessible par gravure isotrope. Sur l'exemple de la figure 9B, on rend la portion restante de SiGe 118 accessible à la gravure en formant la zone active du deuxième transistor MOS 172 orientée (l'orientation correspondant par exemple à l'axe d'alignement de la source, du canal et du drain) avec une rotation de 90° par rapport à la zone active du premier transistor MOS 140.

Sur les exemples des figures 9C et 9D, les zones actives des deux transistors ont des dimensions sensiblement similaires et sont orientées selon une même direction. L'accessibilité à la gravure de la portion de SiGe 118 est obtenue par un décalage partiel (figure 9C, les zones actives se chevauchent partiellement) ou total (figure 9D, les zones actives ne se chevauchent pas) des deux zones actives l'une par rapport à l'autre.

Sur l'exemple de la figure 9E, les dimensions de la zone active, et notamment la largeur de canal, du deuxième transistor MOS 172 sont supérieures à celles de la zone active du premier transistor MOS 140. Comme sur le précédent exemple de la figure 9B, l'accessibilité à la gravure de la portion de SiGe 118 est obtenue par une rotation de 90° des zones actives des deux transistors l'une par rapport à l'autre. Lorsque les dimensions de la zone active du deuxième transistor MOS 172 sont très supérieures à celles de la zone active du premier transistor MOS 140 (voir figure 9F), il est possible, en plus de la rotation de 90°, de décaler également les zones actives des deux transistors l'une par rapport à l'autre.

Lorsque les dimensions de la zone active (largeur de canal) du deuxième transistor MOS 172 sont inférieures à celles de la zone active du premier transistor MOS 140, il est possible de ne pas décaler ni établir de rotation des zones actives des deux transistors l'une par rapport à l'autre car dans ce cas, la portion de SiGe 118 n'est pas totalement recouverte par les portions restantes 152, 154 et 156.

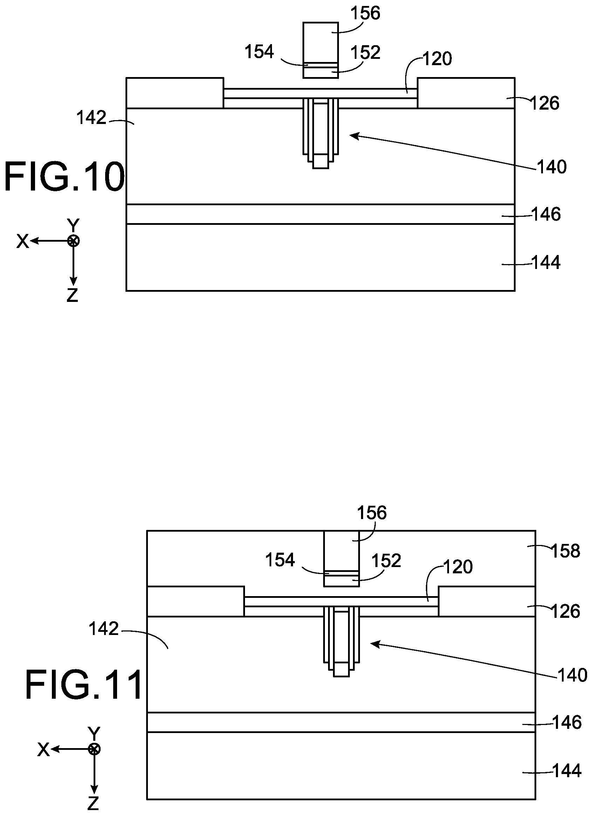

On considère pour la suite que l'on réalise la configuration représentée sur les figures 9A et 9B (zones actives de dimensions similaires et orientées perpendiculairement l'une par rapport à l'autre). Comme représenté sur la figure 10, on élimine la portion restante de SiGe 118, révélant la portion de silicium 120 formant la zone active du premier transistor MOS 140.

On réalise ensuite un dépôt d'un matériau diélectrique 158, par exemple composé d'oxyde de silicium, de nitrure de silicium ou encore de HfO₂, et obtenu par un dépôt CVD, dans le volume précédemment occupé par la portion restante de SiGe 118, mais également autour des portions restantes 152, 154 et 156, et donc autour de la future zone active du deuxième transistor MOS 172, recouvrant également les portions diélectriques 126. Ce matériau diélectrique 158 est ensuite planarisé avec arrêt sur la portion restante de nitrure 156 (figure 11). Le matériau diélectrique 158 forme donc des isolations latérales de type STI autour de la zone active du futur deuxième transistor, et permet d'isoler électriquement les zones actives des deux transistors l'une de l'autre.

Le matériau diélectrique 158 est avantageusement de nature à générer une contrainte dans les canaux des deux transistors MOS afin d'optimiser la mobilité des porteurs dans ces canaux. Un tel matériau diélectrique 158 est par exemple du SiN en tension (« tensile ») dans le cas de transistors PMOS ou du SiN en compression dans le cas de transistors NMOS (cas d'empilements de dispositifs MOS de même conductivité).

Les portions restantes d'oxyde 154 et de nitrure 156 sont ensuite éliminées, révélant la portion de silicium 152 destinée à former la zone active du deuxième transistor MOS 172.

On forme ensuite la grille du deuxième transistor MOS 172. On dépose pour cela un diélectrique de grille 160 (par exemple du SiO₂, du HfO₂, du HfSiON, etc.), un matériau de grille 162 (par exemple du polysilicium) et un masque dur 164. Ces matériaux sont ensuite mis en forme par lithographie et gravure selon le motif de grille souhaité. Un premier espaceur de grille 166 est ensuite formé autour de la grille précédemment réalisée. Une première épitaxie dopée in situ au niveau des régions de source et de drain est mise en œuvre, formant des régions de LDS 167a et LDD 167b. Les dopants sont de type N ou P selon le type du deuxième transistor MOS 172 (par exemple NMOS).

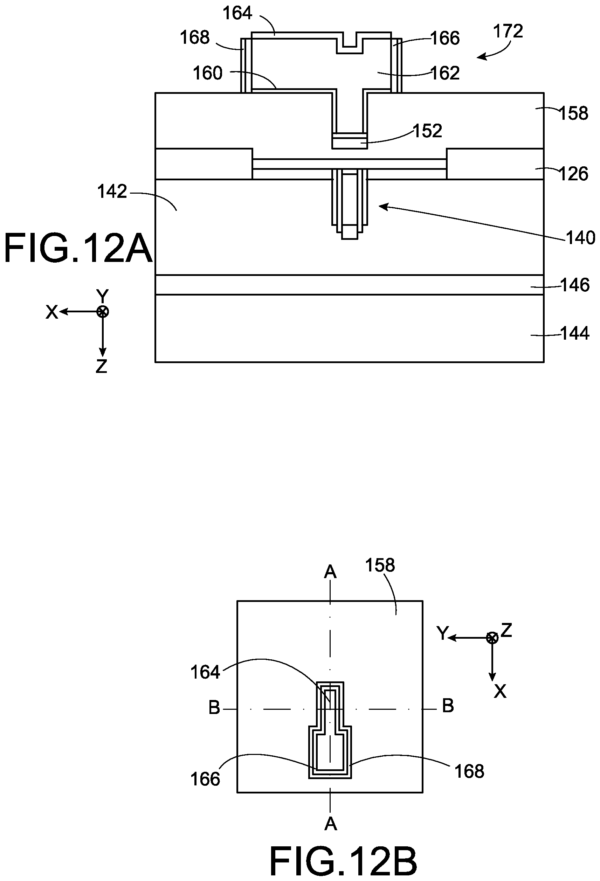

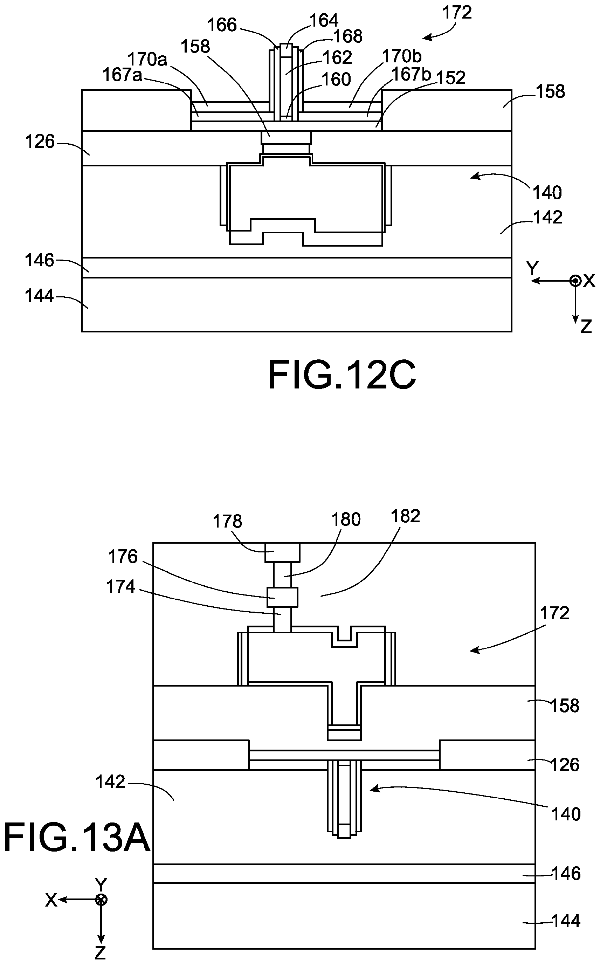

Un deuxième espaceur de grille 168 est réalisé autour du premier espaceur 166. On réalise ensuite une autre épitaxie de silicium au niveau des régions de source 170a et drain 170b du deuxième transistor MOS 172. Un recuit activant les dopants se trouvant dans les régions de source 170a et de drain 170b du deuxième transistor MOS 172 (et pouvant éventuellement activer les dopants du premier transistor MOS 140) est ensuite réalisé. Enfin, une siliciuration des régions de source 170a et de drain 170b est ensuite réalisée. Cette siliciuration, par exemple à base de NiSi, de NiPtSi, de NiSi-SiGe, ou encore de NiPtSi-SiGe, permet de réduire les résistances d'accès aux régions de source 170a et de drain 170b. On obtient ainsi le deuxième transistor MOS 172 (voir figure 12A, 12B et 12C, les figures 12A et 12C représentant respectivement des vues en coupe selon les axes AA et BB représentés sur la figure 12B).

Lorsque deux transistors MOS 140, 172 sont destinés à comporter leurs zones actives reliées électriquement l'un à l'autre (par exemple dans le cas d'un inverseur), il est possible de graver une partie du matériau diélectrique 158 séparant les zones actives des deux transistors afin que, lors du dépôt de métal de siliciuration, ce métal se dépose également dans l'espace gravé et réalise un contact électrique entre les deux zones actives, par exemple entre le drain de l'un des deux transistors et la source de l'autre des deux transistors.

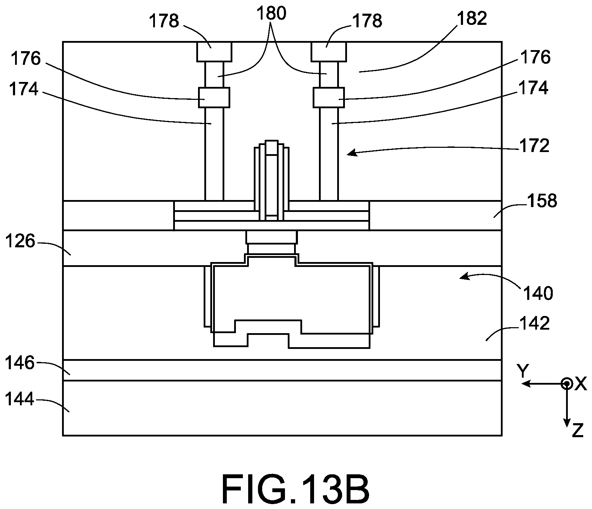

On réalise ensuite des interconnexions électriques reliées au deuxième transistor MOS 172. Ces interconnexions sont formées par des contacts 174 par exemple composés de tungstène et reliés électriquement aux régions de source et de drain, ainsi qu'à la grille du deuxième transistor MOS 172. Des premiers niveaux d'interconnexions électriques 176 et 178, par exemple composés de cuivre, sont ensuite réalisés et reliés électriquement aux contacts 174, ces niveaux étant reliés entre eux par des vias 180. Ces éléments d'interconnexions électriques sont réalisés dans un matériau diélectrique 182 recouvrant l'ensemble du deuxième niveau de transistors 172 (figures 13A et 13B).

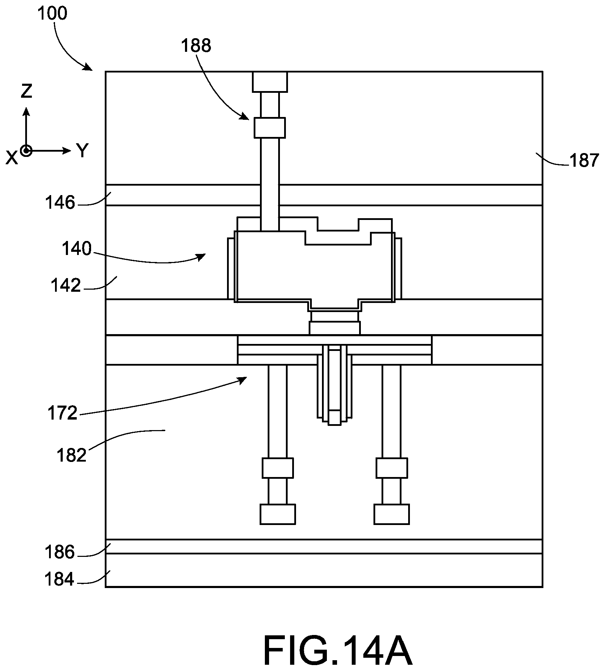

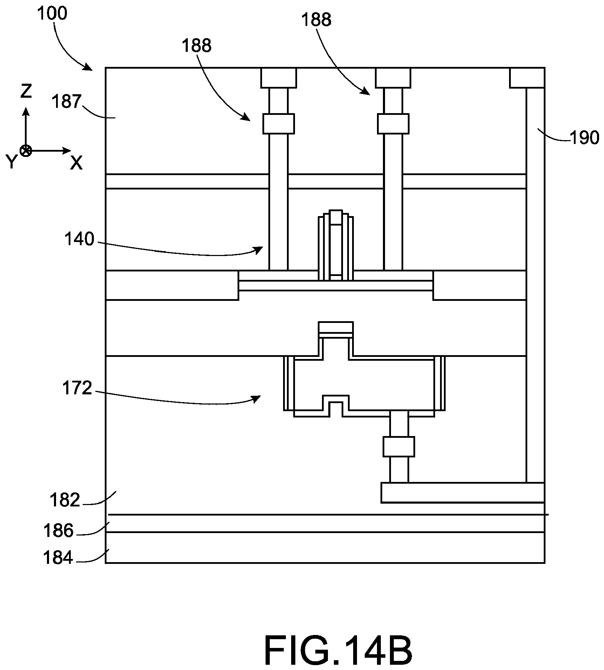

Comme représenté sur les figures 14A et 14B, l'ensemble comprenant les deux transistors 140 et 172 est ensuite reporté sur un troisième substrat de silicium 184 de type Bulk et comportant sur une face une couche d'oxyde 186 composée par exemple de SiO₂ servant d'interface de collage avec le matériau diélectrique 182. Le deuxième substrat 144 est alors éliminé. Un matériau diélectrique 187 est ensuite formé, par exemple par un dépôt d'oxyde, sur la couche d'oxyde 146. Des trous de contacts électriques sont réalisés à travers le matériau diélectrique 187. Ces trous de contact forment des accès aux régions de source et de drain des transistors 140 du premier niveau. On réalise alors une siliciuration de ces régions à travers les trous de contact. En variante, il est possible de déposer, avant la solidarisation au deuxième substrat 114, un nitrure et une couche d'oxyde de collage qui est alors planarisée avant d'être solidarisée au deuxième substrat 144. Après le report sur la troisième substrat 184, l'oxyde de collage est supprimé par exemple par gravure isotrope (HF) avec arrêt sur le nitrure. Le nitrure est ensuite retiré par une gravure sèche et sélective par rapport au silicium. On peut ensuite réaliser la siliciuration des régions de source et de drains des transistors 140 du premier niveau.

Des deuxièmes niveaux d'interconnexions électriques 188 reliés électriquement aux régions de source et de drain et à la grille du premier transistor MOS 140 sont ensuite réalisés de manière analogue aux premiers niveaux interconnexions électriques précédemment réalisées et reliées électriquement au deuxième transistor MOS 172.

Des interconnexions électriques 190 sont également réalisées telles qu'elles relient électriquement des niveaux d'interconnexions électriques des transistors du premier et du deuxième niveau.

Dans le premier mode de réalisation décrit en liaison avec les figures 1 à 14B, la couche sacrificielle 108 composée de SiGe a une épaisseur sensiblement constante. Ainsi, à partir de l'empilement de couches 106, 108 et 110, les zones actives des premiers transistors MOS sont espacées d'une distance constante vis-à-vis des zones actives des deuxièmes transistors MOS. Dans un deuxième mode de réalisation, il est possible de réaliser la couche sacrificielle 108 telle qu'elle comporte des zones d'épaisseurs différentes. Il est donc possible de moduler la distance séparant les zones actives d'un premier et d'un deuxième transistor MOS réalisés l'un en face de l'autre, et donc de réaliser une modulation du couplage capacitif entre ces deux transistors.

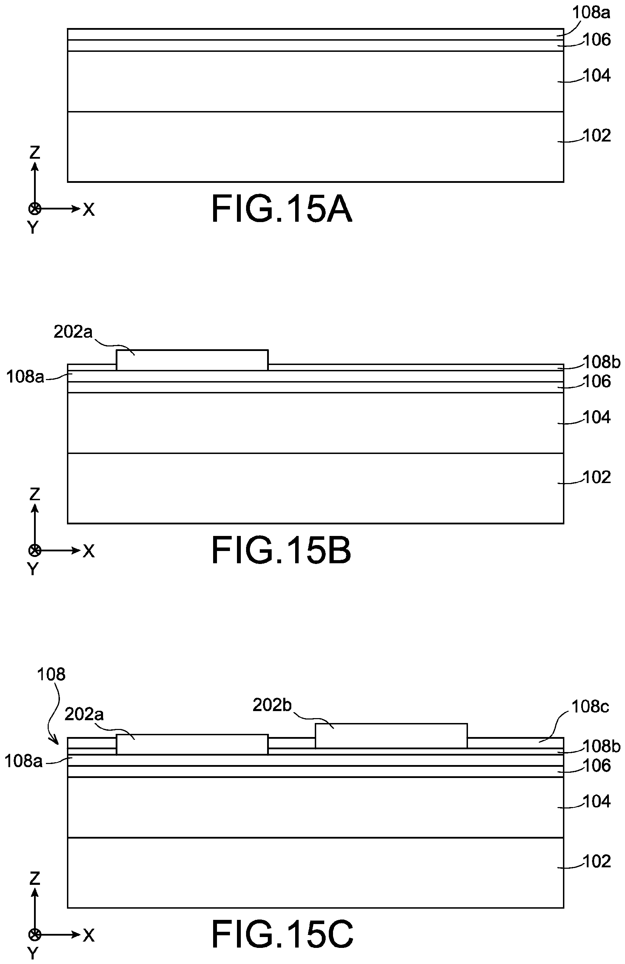

Pour cela, comme représenté sur la figure 15A, on réalise, à partir du substrat SOI comprenant la couche support de silicium 102, la couche diélectrique 104 et la deuxième couche de silicium 106, une première épitaxie de SiGe, formant une première partie 108a de la couche sacrificielle 108 dont l'épaisseur est par exemple comprise entre environ 5 nm et 30 nm.

Un premier masque 202a, dont le motif délimite les parties du substrat au niveau desquelles on souhaite que la couche sacrificielle 108 ait une épaisseur égale à celle de la première partie 108a, est réalisé sur la première partie 108a de la couche sacrificielle. On réalise ensuite une deuxième épitaxie 108b de SiGe, formant une deuxième partie 108b de la couche sacrificielle 108 autour du premier masque 202a, dont l'épaisseur est par exemple comprise entre environ 5 nm et 30 nm (voir figure 15B).

Un deuxième masque 202b, dont le motif délimite les parties du substrat au niveau desquelles on souhaite que la couche sacrificielle 108 ait une épaisseur égale à la somme des épaisseurs de la première partie 108a et de la deuxième partie 108b, est réalisé sur la deuxième partie 108b de la couche sacrificielle. On réalise ensuite une troisième épitaxie 108c de SiGe, formant une troisième partie 108c de la couche sacrificielle 108 autour du premier masque 202a et du deuxième masque 202b, dont l'épaisseur est par exemple comprise entre environ 5 nm et 30 nm (voir figure 15C).

Lorsque les couches 108a, 108b et 108c sont composée de SiGe 30%, l'épaisseur totale de ces couches peut être inférieure ou égale à environ 100 nm afin d'éviter des défauts liés à la relaxation de ces couches.

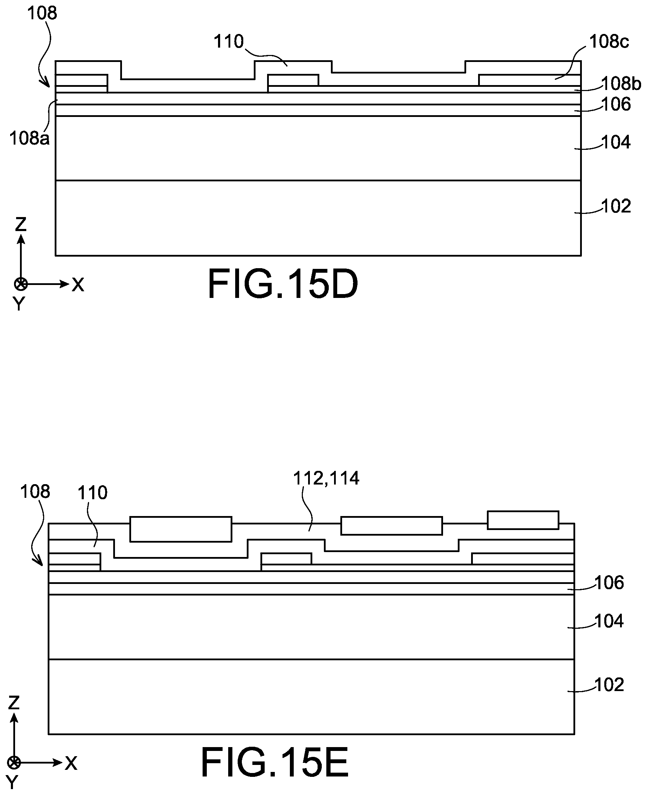

Comme représenté sur la figure 15D, les masques 202a, 202b sont ensuite retirés puis la première couche de semi-conducteur 110 est déposée de manière conforme, par exemple par épitaxie de silicium, sur la couche sacrificielle 108 d'épaisseur variable, épousant ainsi les différentes épaisseurs de la couche sacrificielle 108.

Dans l'exemple décrit ici, la couche sacrificielle 108 comporte trois épaisseurs différentes. De manière générale, le nombre d'épaisseurs différentes de la couche sacrificielle 108 peut être différent de trois et correspond au nombre de modulations différentes que l'on souhaite réaliser entre les premiers dispositifs MOS et les deuxièmes dispositifs MOS.

Comme représenté sur la figure 15E, on réalise ensuite, sur la première couche de semi-conducteur 110, les couches d'oxyde 112 et de nitrure 114. Les couches 112 et 114 ont une épaisseur variable telle qu'elles forment une face supérieure plane. On réalise des étapes de photolithographie et gravure des couches 108, 110, 112 et 114 selon un motif définissant des zones actives des premiers transistors MOS. La gravure est arrêtée sur la deuxième couche de semi-conducteur 106.

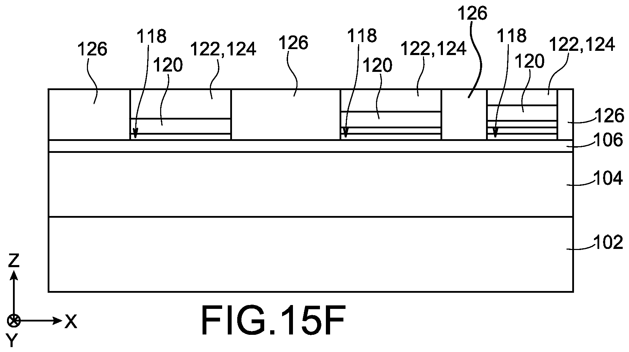

Un matériau diélectrique est ensuite déposé autour de portions restantes 118, 120, 122 et 124, formant les portions diélectriques 126 isolant latéralement (STI) les futures zones actives des premiers transistors MOS (figure 15F). Ces isolations latérales 126 sont par exemple réalisées comme dans le premier mode de réalisation.

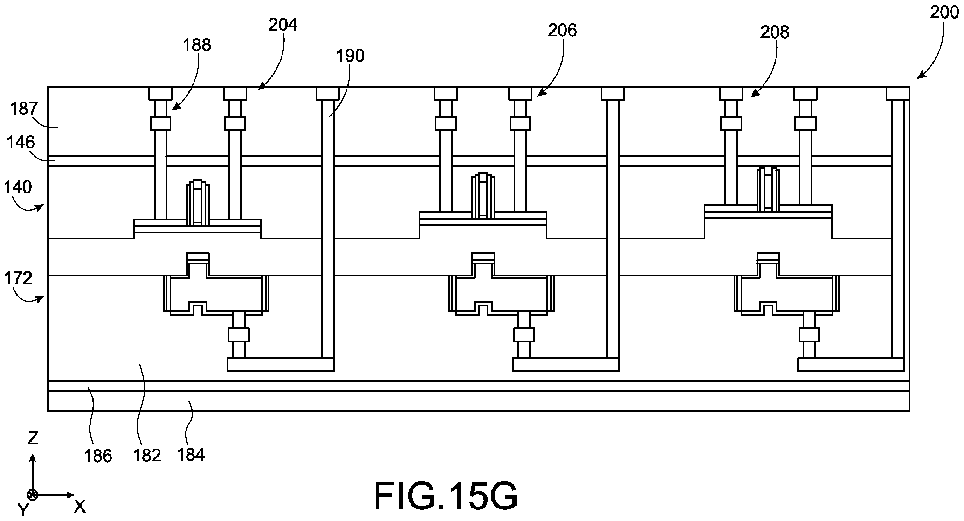

Le circuit intégré 200 est ensuite achevé de manière analogue au circuit intégré 100 précédemment décrit. Comme représenté sur la figure 15G, le circuit intégré 200 comporte une partie 204 dans laquelle le premier transistor MOS 140 présente un fort couplage capacitif avec le deuxième transistor MOS 172 (transistors réalisés au niveau d'une portion 118 de la couche sacrificielle 108 d'épaisseur égale à celle de la première partie 108a), permettant de moduler les tensions de seuil de l'un par rapport à l'autre. Le circuit intégré 200 comporte également une partie 206 dans laquelle le premier transistor MOS 140 présente un couplage capacitif moyen avec le deuxième transistor MOS 172 (transistors réalisés au niveau d'une portion 118 de la couche sacrificielle 108 d'épaisseur égale à celle de la somme de la première partie 108a et de la deuxième partie 108b), et une partie 208 dans laquelle le premier transistor MOS 140 présente un faible couplage capacitif avec le deuxième transistor MOS 172 (transistors réalisés au niveau d'une portion 118 de la couche sacrificielle 108 d'épaisseur égale à la somme de la première partie 108a, de la deuxième partie 108b et de la troisième partie 108c).

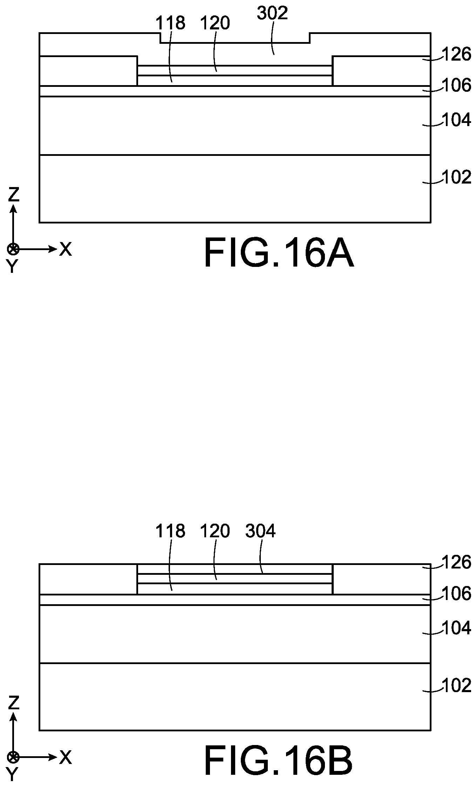

On décrit maintenant en liaison avec les figures 16A à 16D la réalisation d'un circuit intégré tridimensionnel 300 selon un troisième mode de réalisation.

On réalise tout d'abord les étapes précédemment décrites en liaison avec les figures 1 à 4, formant les futures zones actives des premiers transistors MOS délimitées par les portions diélectriques 126.

Les futures zones actives des premiers transistors du type NMOS, sont alors masquées en réalisant un dépôt de nitrure 302, une photolithographie et une gravure du nitrure 302 (figure 16A). On réalise ensuite une épitaxie de SiGe 304 sur les portions de silicium 120 non masquées qui correspondent donc aux futures zones actives des premiers transistors du type PMOS (voir figure 16B).

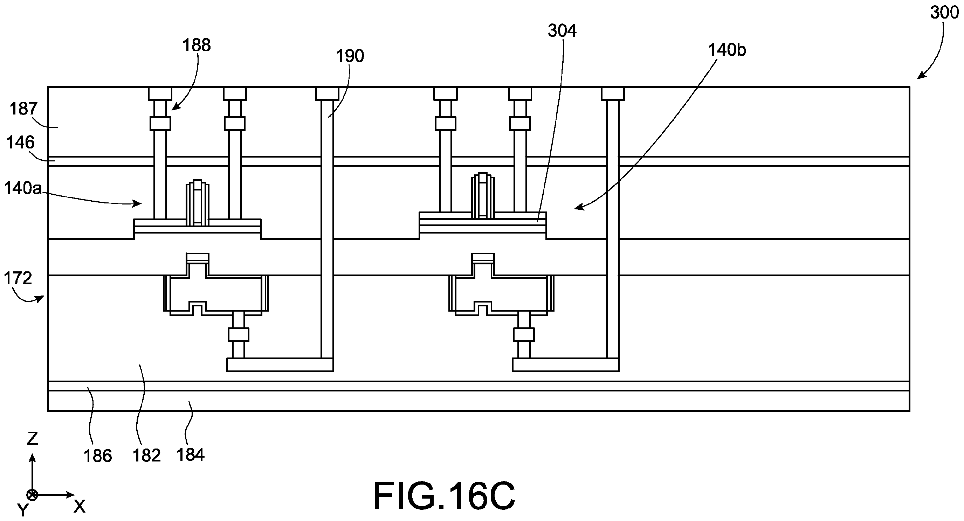

Le circuit intégré 300 est achevé de manière analogue au premier mode de réalisation. Comme représenté sur la figure 16C, le circuit intégré 300 obtenu comporte des premiers transistors MOS, et notamment des premiers transistors NMOS 140a dont les zones actives sont composées du semi-conducteur des portions 120 et des premiers transistors PMOS 140b dont les zones actives sont composées du semi-conducteur des portions 120 et du SiGe 304 obtenu par épitaxie sur le semi-conducteur des portions 120.

En variante, il est possible de réaliser les premiers transistors MOS tels que ceux du type PMOS comportent des zones actives composées uniquement du semi-conducteur des portions 120 et que ceux du type NMOS comportent des zones actives composées du semi-conducteur des portions 120 et du SiGe 304 obtenu par épitaxie sur le semi-conducteur des portions 120. Dans une autre variante, il est possible que l'épitaxie de SiGe soit réalisée à la fois pour les premiers transistors NMOS et PMOS.

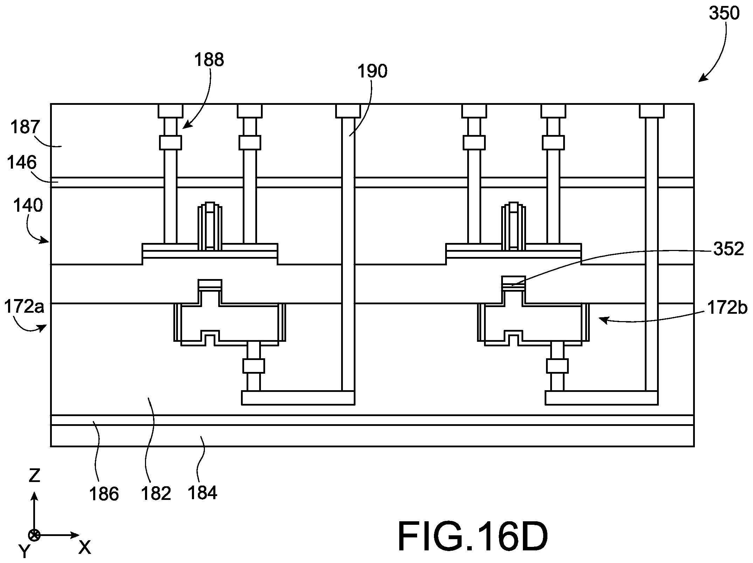

Dans une autre variante, il est possible que l'épitaxie de SiGe ne soit pas réalisée pour les zones actives des premiers transistors MOS, mais pour au moins une partie des deuxièmes transistors MOS. Dans cette variante, les étapes précédemment décrites en liaison avec les figures 1 à 11 sont mises en œuvre comme précédemment décrit. Les portions restantes d'oxyde 154 et de nitrure 156 sont ensuite éliminées, révélant les portions de silicium 152 destinées à former les zones actives des deuxièmes transistors. Les portions de silicium 152 des futurs deuxièmes transistors NMOS sont ensuite masquées. Une épitaxie de SiGe 352 est ensuite réalisée sur les portions de silicium 152 des futurs deuxièmes transistors PMOS. Le circuit intégré 350 obtenu est représenté sur la figure 16D et comporte des premiers transistors MOS 140, des deuxièmes transistors NMOS 172a dont les zones actives sont composées du semi-conducteur des portions 152 et des deuxièmes transistors PMOS 172b dont les zones actives sont composées du semi-conducteur des portions 152 et du SiGe 352 obtenu par épitaxie sur le semi-conducteur des portions 152.

Comme pour le circuit intégré 300 précédemment décrit, il est possible de réaliser les deuxièmes transistors tels que les deuxièmes transistors PMOS comportent des zones actives composées uniquement du semi-conducteur des portions 152 et des deuxièmes transistors NMOS dont les zones actives sont composées du semi-conducteur des portions 152 et du SiGe 352 obtenu par épitaxie sur le semi-conducteur des portions 152. Dans une autre variante, il est possible que l'épitaxie de SiGe soit réalisée à la fois pour les deuxièmes transistors NMOS et PMOS.

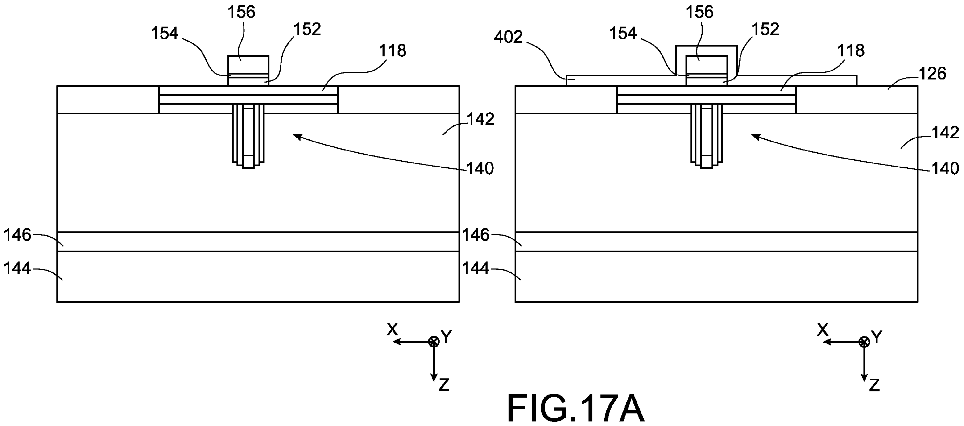

On décrit maintenant en liaison avec les figures 17A à 17E la réalisation d'un circuit intégré tridimensionnel 400 selon un quatrième mode de réalisation.

On réalise tout d'abord les étapes précédemment décrites en liaison avec les figures 1 à 9G, formant les premiers transistors MOS et les futures zones actives des deuxièmes transistors MOS. Dans ce quatrième mode de réalisation, au moins une partie des premiers et deuxièmes transistors MOS sont remplacés par des cellules mémoires de type flash. Pour cela, on recouvre éventuellement les deuxièmes transistors MOS que l'on souhaite conserver en tant que transistors (ainsi que les premiers transistors MOS disposés en regard de ces deuxièmes transistors) par un masque 402 (figure 17A).

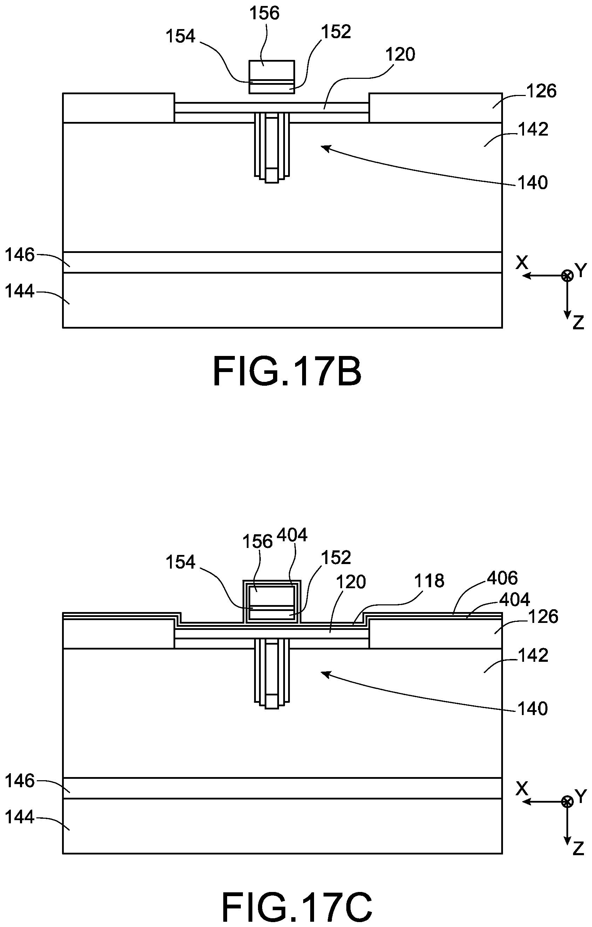

Comme représenté sur la figure 17B, on grave ensuite les portions 118 de SiGe au niveau des dispositifs MOS destinés à former des cellules mémoires. Une première couche d'oxyde 404 est déposée de manière conforme sur l'ensemble précédemment réalisé, recouvrant notamment les portions de silicium 120 formant les zones actives des premiers dispositifs MOS ainsi que les empilements des portions de matériau 152, 154 et 156. Une deuxième couche de nitrure 406 est ensuite déposée de manière à recouvrir la première couche d'oxyde 404 (figure 17C).

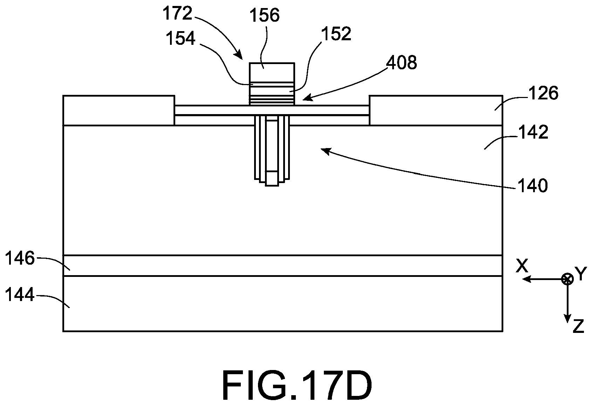

Comme représenté sur la figure 17D, les couches 404 et 406 sont alors gravées, seules les portions de ces couches se trouvant entre le silicium de la portion 152 et le silicium formant les zones actives des premiers dispositifs MOS étant conservées, formant un empilement mémoire 408 de type ONO (oxyde - nitrure - oxyde, la portion de nitrure étant destinée à réaliser une rétention de charges électriques correspondant à une mémorisation de données).

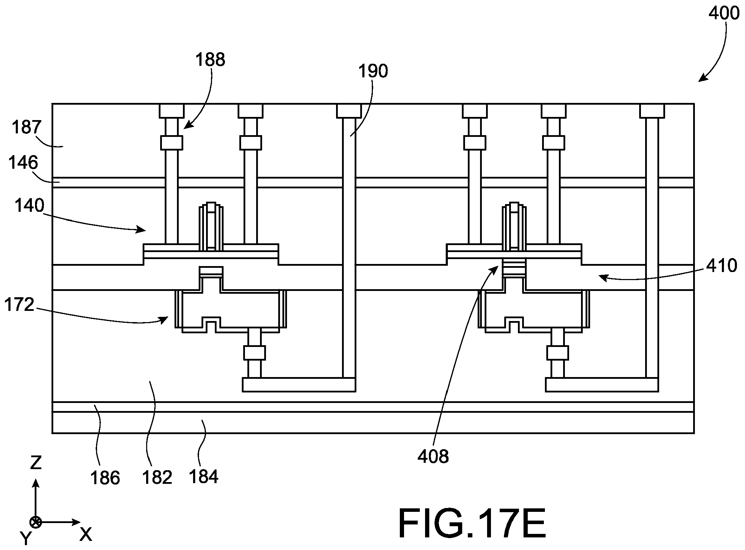

Le circuit intégré 400 est ensuite achevé de manière analogue au circuit intégré 100 selon le premier mode de réalisation (figure 17E). Le circuit intégré 400 comporte des premiers transistors MOS 140 et des deuxièmes transistors MOS 172, ainsi que des cellules mémoires de type Flash 410, comprenant chacune des dispositifs MOS réalisés dans les deux niveaux MOS et un empilement mémoire 408.

Dans une variante, il est possible que le circuit intégré 400 ne comporte que des cellules mémoires de type Flash. Dans ce cas, l'étape de masquage précédemment décrite en liaison avec la figure 17A n'est pas mise en œuvre.

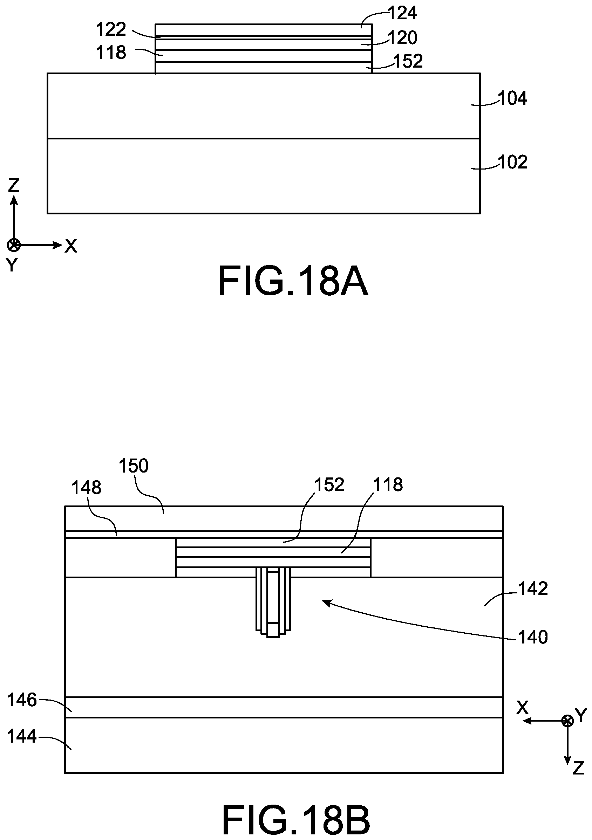

On décrit maintenant en liaison avec les figures 18A à 18E la réalisation d'un circuit intégré tridimensionnel 500 selon un cinquième mode de réalisation, dans lequel au moins une partie des premiers et deuxièmes transistors ont des zones actives auto-alignées les unes par rapport aux autres.

On réalise tout d'abord les étapes précédemment décrites en liaison avec les figures 1, 2A et 2B. Les futurs premiers et deuxièmes transistors MOS qui ne sont pas destinés à avoir leurs zones actives auto-alignées les unes par rapport aux autres sont ensuite masqués. La deuxième couche de semi-conducteur 106 est ensuite gravée selon le même motif que celui des couches 108, 110, 112 et 114. Ainsi, les zones actives des deuxièmes transistors ont un motif similaire à celui des zones actives des premiers transistors.

Les étapes précédemment décrites en liaison avec les figures 3 à 8 sont ensuite mises en œuvre de manière analogue, aboutissant à la structure représentée sur la figure 18B.

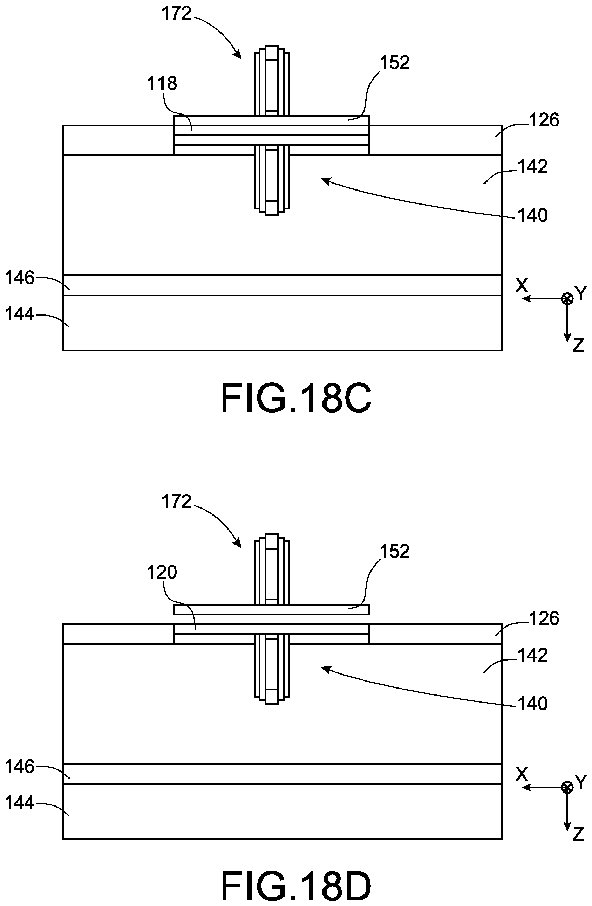

Etant donné que le motif de la portion de SiGe 118 est similaire à celui de la portion de semi-conducteur 152, il n'est pas possible, contrairement aux précédents modes de réalisation, de graver cette portion de SiGe avant d'avoir réalisé et gravé les matériaux de grille des deuxièmes transistors, ou après avoir réalisé les espaceurs de grille des deuxièmes transistors par une gravure isotrope. Comme représenté sur la figure 18C, on réalise donc les grilles des deuxièmes transistors en mettant en œuvre des étapes analogues à celles précédemment décrites en liaison avec les figures 5A et 5B (dépôt et gravure d'un diélectrique de grille, d'un matériau de grille, d'un masque dur, d'un ou plusieurs espaceurs, ...). Etant donné que les zones actives des premiers et deuxièmes transistors sont superposées les unes au-dessus des autre selon un motif similaire, les grilles des premiers et deuxièmes transistors pourront être alignées et comporter un motif similaire.

Comme représenté sur la figure 18D, on grave une partie des portions diélectriques 126 afin de révéler au moins une partie des flancs latéraux de la portion de matériau sacrificiel 118. Cette portion de SiGe 118 est ensuite gravée par une gravure isotrope.

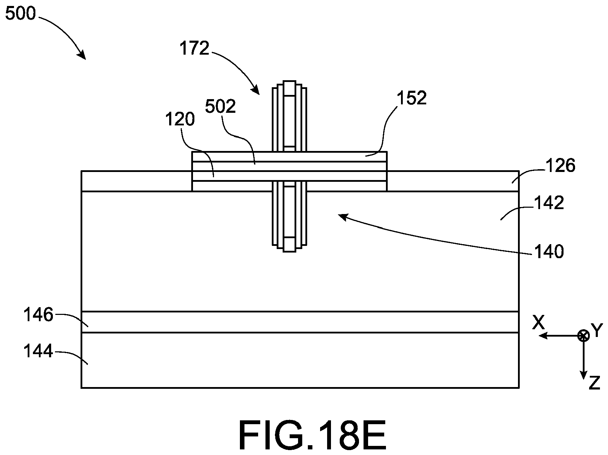

L'espace entre les portions de semi-conducteur 120 et 152 formant les zones actives des premiers et deuxièmes transistors, obtenu en gravant la portion de matériau sacrificiel 118, est ensuite rempli en réalisant un dépôt de matériau diélectrique puis une désoxydation, ne conservant qu'une portion diélectrique 502 dont le motif est similaire à celui des portions de semi-conducteur 120 et 152 (figure 18E). Le circuit intégré 500 est ensuite achevé de manière analogue au circuit intégré 100 précédemment décrit.

Que les zones actives soient réalisées de manière auto-alignée ou non, il est possible de supprimer la portion de SiGe 118 qu'après avoir réalisé la gravure des grilles des deuxièmes transistors ou achevé la gravure des espaceurs autour des grilles des deuxièmes transistors.

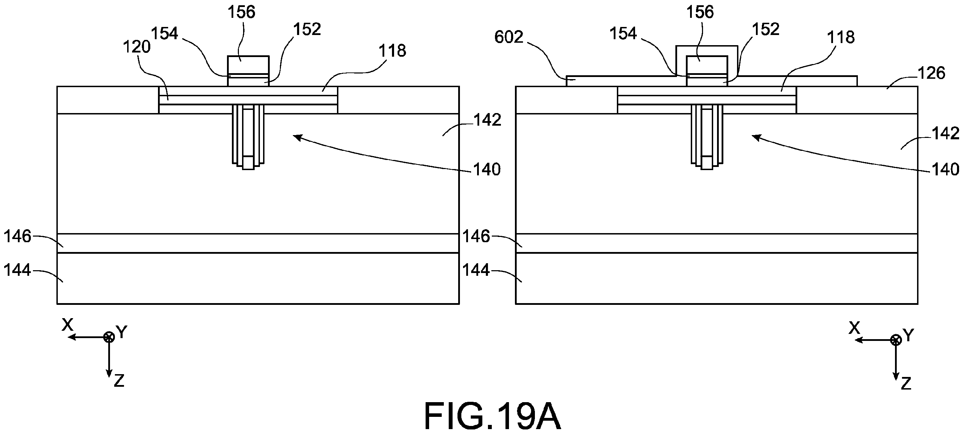

On décrit maintenant en liaison avec les figures 19A à 19D la réalisation d'un circuit intégré tridimensionnel 600 selon un sixième mode de réalisation.

On réalise tout d'abord les étapes précédemment décrites en liaison avec les figures 1 à 9G, formant les premiers dispositifs MOS 140 et les futures zones actives des deuxièmes dispositifs MOS 172. Dans ce sixième mode de réalisation, au moins une partie des premiers et deuxièmes dispositifs MOS sont destinés à comporter un plan de masse (« ground plane »), ou grille flottante. Pour cela, on recouvre éventuellement les deuxièmes dispositifs MOS 172 qui ne sont pas destinés à recevoir un tel plan de masse (ainsi que les premiers dispositifs MOS disposés en regard de ces deuxièmes transistors MOS) par un masque 602 (figure 19A).

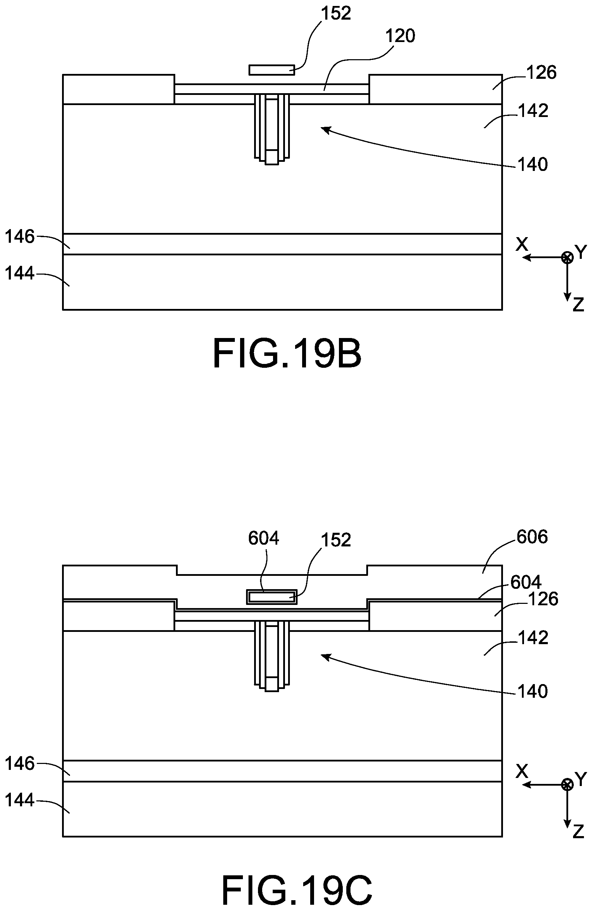

Comme représenté sur la figure 19B, on grave ensuite les portions de SiGe 118 au niveau des dispositifs MOS destinés à comporter un plan de masse. Les portions d'oxyde et de nitrure 154 et 156 sont également supprimées.

Le masque 602 est ensuite supprimé. On réalise alors le dépôt d'un matériau diélectrique 604 destiné à former les diélectriques de grille des deuxièmes transistors MOS 174 et le dépôt d'un matériau de grille 606 destiné à former la grille des deuxièmes transistors MOS 174. Au niveau des dispositifs MOS destinés à comporter un plan de masse, dans lesquels les portions de matériau sacrificiel 118 ont été gravées, le matériau diélectrique 604 recouvre également les portions de semi-conducteur 120 et entoure les portions de semi-conducteur 152, et le matériau de grille 606 rempli l'espace restant précédemment occupé par les portions de SiGe 118 (figure 19C).

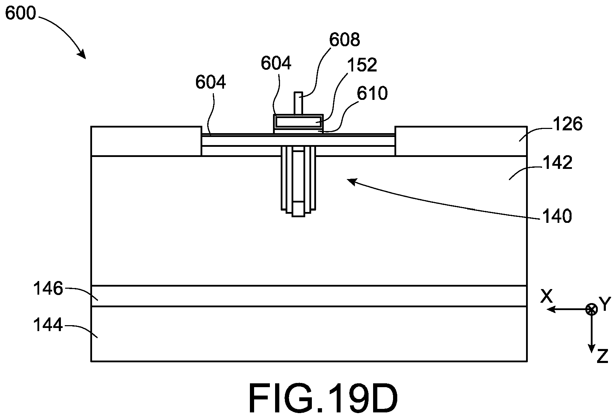

Comme représenté sur la figure 19D, on réalise une lithographie et gravure (stripping) du matériau de grille 606, formant la grille 608 des deuxièmes transistors MOS 172 mais également un plan de masse 610 composé du matériau de grille et gravé selon un motif correspondant à celui de la portion de semi-conducteur 152 destinée à former les zones actives des deuxièmes transistors MOS 172. Le circuit intégré 600 est ensuite achevé de manière analogue au circuit intégré 100 précédemment décrit.

Dans les modes de réalisation précédemment décrits, les deux dispositifs MOS du circuit électronique intégré sont représentés avec un angle de rotation d'environ 90° l'un par rapport à l'autre. Les deux dispositifs MOS peuvent toutefois être complètement alignés l'un par rapport à l'autre, sans angle de rotation l'un par rapport à l'autre.

## Revendications

1. Procédé de réalisation d'un circuit électronique intégré (100-600) comportant au moins les étapes de :
- réalisation d'un substrat comportant au moins une première (110) et une deuxième (106) couches de semi-conducteur entre lesquelles est disposée au moins une troisième couche de matériau (108), puis
- réalisation d'au moins un premier dispositif MOS (140) dont une zone active est formée dans au moins une partie (120) de la première couche de semi-conducteur (110), puis
- réalisation d'au moins un deuxième dispositif MOS (172) dont une zone active est formée dans au moins une partie (152) de la deuxième couche de semi-conducteur (106), la zone active du deuxième dispositif MOS (172) étant disposée entre une grille (162) du deuxième dispositif MOS (172) et la zone active du premier dispositif MOS (140).

2. Procédé selon la revendication 1, dans lequel la première couche de semi-conducteur (110), la deuxième couche de semi-conducteur (106) et la troisième couche de matériau (108) sont à base de semi-conducteurs monocristallins réalisés par épitaxie.

3. Procédé selon l'une des revendications précédentes, dans lequel la troisième couche (108) est composée au moins de SiGe ou de silicium poreux.

4. Procédé selon l'une des revendications précédentes, dans lequel, lors de la réalisation du premier dispositif MOS (140), la première couche de semi-conducteur (110) et la troisième couche (108) sont gravées selon un même motif correspondant à la zone active du premier dispositif MOS (140).

5. Procédé selon l'une des revendications précédentes, dans lequel, lors de la réalisation du premier dispositif MOS (140), la première (110) et la deuxième (106) couches de semi-conducteur et la troisième couche (108) sont gravées selon un même motif correspondant aux zones actives du premier (140) et du deuxième (172) dispositifs MOS.

6. Procédé selon l'une des revendications 4 ou 5, comportant en outre, lors de la réalisation du deuxième dispositif MOS (172), la mise en œuvre des étapes de :
- retrait d'une portion restante (118) de la troisième couche (108) gravée selon le motif correspondant à la zone active du premier dispositif MOS (140),
- dépôt d'un matériau diélectrique (158) au moins entre les zones actives du premier (140) et du deuxième (172) dispositifs MOS.

7. Procédé selon l'une des revendications 4 ou 5, comportant en outre, lors de la réalisation du deuxième dispositif MOS (172), la mise en œuvre des étapes de :
- retrait d'une portion restante (118) de la troisième couche (108) gravée selon le motif correspondant à la zone active du premier dispositif MOS (140),
- réalisation, entre les zones actives du premier (140) et du deuxième (172) dispositifs MOS, d'un empilement comportant une portion de matériau électriquement conducteur (610) disposée entre deux portions de matériau diélectrique (604).

8. Procédé selon l'une des revendications précédentes, dans lequel les dispositifs MOS (140, 172) sont des transistors.

9. Procédé selon l'une des revendications 4 ou 5, comportant en outre, lors de la réalisation du deuxième dispositif MOS (172), la mise en œuvre des étapes de :
- retrait d'une portion restante (118) de la troisième couche (108) gravée selon le motif correspondant à la zone active du premier dispositif MOS (140),
- réalisation, entre les zones actives du premier (140) et du deuxième (172) dispositifs MOS, d'un empilement mémoire (408) comportant une portion de matériau (406) apte à réaliser une rétention de charges électriques disposée entre deux portions de matériau diélectrique (404),
les premier (140) et deuxième (172) dispositifs MOS formant une cellule mémoire.

10. Procédé selon l'une des revendications précédentes, comportant en outre, entre les étapes de réalisation du premier (140) et du deuxième (172) dispositifs MOS, les étapes de :
- dépôt d'un matériau diélectrique (142) recouvrant au moins le premier dispositif MOS (140),
- solidarisation dudit matériau diélectrique (142) contre un deuxième substrat (144).

11. Procédé selon la revendication 10, comportant en outre, après la réalisation du deuxième dispositif MOS (172), les étapes de :
- dépôt d'un matériau diélectrique (182) recouvrant le deuxième dispositif MOS (172),
- réalisation, au moins dans le matériau diélectrique (182) recouvrant le deuxième dispositif MOS (172), d'au moins un premier niveau d'interconnexions électriques (176, 178) et un ou plusieurs vias (174, 180) reliant électriquement le deuxième dispositif MOS (172) au premier niveau d'interconnexions électriques (176, 178), le deuxième dispositif MOS (172) étant disposé entre le premier niveau d'interconnexions électriques (176, 178) et le premier dispositif MOS (140).

12. Procédé selon la revendication 11, comportant en outre, après la réalisation du premier niveau d'interconnexions électriques (176, 178), les étapes de :
- solidarisation du matériau diélectrique (182) recouvrant le deuxième dispositif MOS (172) contre un troisième substrat (184),
- retrait du deuxième substrat (144),
- réalisation, au moins dans un matériau diélectrique (187) recouvrant le premier dispositif MOS (140), d'au moins un deuxième niveau d'interconnexions électriques (188) et un ou plusieurs vias reliant électriquement le premier dispositif MOS (140) au deuxième niveau d'interconnexions électriques (188), le premier dispositif MOS (140) étant disposé entre le deuxième niveau d'interconnexions électriques (188) et le deuxième dispositif MOS (172).

13. Procédé selon l'une des revendications précédentes, dans lequel la troisième couche (108) comporte des régions (108a, 108b, 108c) d'épaisseurs différentes telles que, lorsque le procédé comporte la réalisation de plusieurs premiers dispositifs MOS (140) et de plusieurs deuxièmes dispositifs MOS (172), les distances entre les zones actives d'un premier (140) et d'un deuxième (172) dispositifs MOS réalisés l'un au-dessus de l'autre correspondent aux différentes épaisseurs de la troisième couche (108).

14. Procédé selon la revendication 13, dans lequel la troisième couche (108) qui comporte des régions (108a, 108b, 108c) d'épaisseurs différentes est obtenue en réalisant plusieurs étapes successives d'épitaxie (108a, 108b, 108c) du matériau de la troisième couche (108) sur la deuxième couche de semi-conducteur (106) au cours desquelles des masques (202a, 202b) sont réalisés sur les couches épitaxiées (108a, 108b) afin de former les régions d'épaisseurs différentes de la troisième couche (108).

15. Procédé selon l'une des revendications précédentes, dans lequel, lorsque le premier (140) dispositif MOS est de type PMOS, la réalisation du premier (140) dispositif PMOS comporte la mise en œuvre d'une épitaxie de SiGe (304) sur la partie (120) de la première (110) couche de semi-conducteur destinée à former la zone active du premier (140) dispositif PMOS, et/ou, lorsque le deuxième dispositif MOS (172) est de type PMOS, la réalisation du deuxième dispositif PMOS (172) comporte la mise en œuvre d'une épitaxie de SiGe (352) sur la partie (152) de la deuxième couche de semi-conducteur (106) destinée à former la zone active du deuxième dispositif PMOS (172).

## Patentansprüche

1. Verfahren zur Herstellung einer integrierten elektronischen Schaltung (100-600), umfassend mindestens die Schritte von:
- Herstellen eines Substrats, umfassend mindestens eine erste (110) und eine zweite (106) Halbleiterschicht, zwischen denen mindestens eine dritte Schicht aus einem Material (108) angeordnet ist, dann
- Herstellen mindestens einer ersten MOS-Vorrichtung (140) mit einem aktiven Bereich, der in mindestens einem Teil (120) der ersten Halbleiterschicht (110) ausgebildet ist, und dann
- Herstellen mindestens einer zweiten MOS-Vorrichtung (172), bei der ein aktiver Bereich in mindestens einem Teil (152) der zweiten Halbleiterschicht (106) gebildet ist, wobei der aktive Bereich der zweiten MOS-Vorrichtung (172) zwischen einem Gate (162) der zweiten MOS-Vorrichtung (172) und dem aktiven Bereich der ersten MOS-Vorrichtung (140) angeordnet ist.

2. Verfahren gemäß Anspruch 1, wobei die erste Halbleiterschicht (110), die zweite Halbleiterschicht (106) und die dritte Materialschicht (108) auf monokristallinen Halbleitern basieren, die durch Epitaxie erzeugt werden.

3. Verfahren gemäß einem der vorhergehenden Ansprüche, wobei die dritte Schicht (108) aus mindestens SiGe oder porösem Silizium aufgebaut ist.

4. Verfahren gemäß einem der vorhergehenden Ansprüche, bei dem, wenn die erste MOS-Vorrichtung (140) hergestellt wird, die erste Halbleiterschicht (110) und die dritte Schicht (108) in einem gleichen Muster geätzt werden, das dem aktiven Bereich der ersten MOS-Vorrichtung (140) entspricht.

5. Verfahren gemäß einem der vorhergehenden Ansprüche, bei dem, wenn die erste MOS-Vorrichtung (140) hergestellt wird, die erste (110) und zweite (106) Halbleiterschicht und die dritte (108) Schicht in einem gleichen Muster geätzt werden, das den aktiven Bereichen der ersten (140) und zweiten (172) MOS-Vorrichtungen entspricht.

6. Verfahren gemäß einem der Ansprüche 4 oder 5, ferner umfassend, während der Herstellung der zweiten MOS-Vorrichtung (172), die Durchführung der Schritte von:
- Entfernen eines verbleibenden Abschnitts (118) der dritten Schicht (108), die gemäß dem Muster, das dem aktiven Bereich der ersten MOS-Vorrichtung (140) entspricht, graviert sind,
- Ablagern eines dielektrischen Materials (158) mindestens zwischen den aktiven Bereichen der ersten (140) und zweiten (172) MOS-Vorrichtungen.

7. Verfahren gemäß einem der Ansprüche 4 oder 5, ferner umfassend, während der Herstellung der zweiten MOS-Vorrichtung (172), die Durchführung der Schritte von:
- Entfernen eines verbleibenden Abschnitts (118) der dritten Schicht (108), die gemäß dem Muster, das dem aktiven Bereich der ersten MOS-Vorrichtung (140) entspricht, graviert sind,
- Herstellen, zwischen den aktiven Bereichen der ersten (140) und zweiten (172) MOS-Vorrichtungen, eines Stapels, der einen Abschnitt aus elektrisch leitfähigem Material (610) umfasst, der zwischen zwei Abschnitten aus einem dielektrischen Material (604) angeordnet ist.

8. Verfahren gemäß einem der vorhergehenden Ansprüche, wobei die MOS-Vorrichtungen (140, 172) Transistoren sind.

9. Verfahren gemäß einem der Ansprüche 4 oder 5, ferner umfassend, während der Herstellung der zweiten MOS-Vorrichtung (172), die Durchführung der Schritte von:
- Entfernen eines verbleibenden Abschnitts (118) der dritten Schicht (108), der in dem Muster, das dem aktiven Bereich der ersten MOS-Vorrichtung (140) entspricht, geätzt wurde,
- Herstellen, zwischen den aktiven Bereichen der ersten (140) und zweiten (172) MOS-Vorrichtungen, eines Speicherstapels (408), der einen Materialabschnitt (406) umfasst, der in der Lage ist, eine elektrische Ladungsrückhaltung durchzuführen, die zwischen zwei Abschnitten des dielektrischen Materials (404) angeordnet ist, wobei die erste (140) und zweite (172) MOS-Vorrichtung eine Speicherzelle bilden.

10. Verfahren gemäß einem der vorhergehenden Ansprüche, ferner umfassend, zwischen den Schritten des Herstellens der ersten (140) und zweiten (172) MOS-Vorrichtungen, die Schritte von:
- Ablagern eines dielektrischen Materials (142), das mindestens die erste MOS-Vorrichtung (140) bedeckt,
- Verfestigen des dielektrischen Materials (142) auf einem zweiten Substrat (144).

11. Verfahren gemäß Anspruch 10, ferner umfassend nach der Herstellung der zweiten MOS-Vorrichtung (172) die Schritte von:
- Ablagern eines dielektrischen Materials (182), das die zweite MOS-Vorrichtung (172) bedeckt,
- Herstellen, zumindest in dem dielektrischen Material (182), das die zweite MOS-Vorrichtung (172) bedeckt, von mindestens einer ersten Ebene von elektrischen Verbindungen (176, 178) und einem oder mehreren Durchkontaktierungen (174, 180), die die zweite MOS-Vorrichtung (172) elektrisch mit der ersten Ebene von elektrischen Verbindungen (176, 178) verbinden, wobei die zweite MOS-Vorrichtung (172) zwischen der ersten Ebene von elektrischen Verbindungen (176, 178) und der ersten MOS-Vorrichtung (140) angeordnet ist.

12. Verfahren gemäß Anspruch 11, ferner umfassend nach dem Herstellung der ersten Ebene der elektrischen Verbindungen (176, 178) die Schritte von:
- Verfestigen des dielektrischen Materials (182), das die zweite MOS-Vorrichtung (172) bedeckt, auf einem dritten Substrat (184),
- Entfernen des zweiten Substrats (144),
- Herstellen, zumindest in einem dielektrischen Material (187), das die erste MOS-Vorrichtung (140) bedeckt, von mindestens einer zweiten Ebene von elektrischen Verbindungen (188) und einem oder mehreren Durchkontaktierungen, die die erste MOS-Vorrichtung (140) elektrisch mit der zweiten Ebene von elektrischen Verbindungen (188) verbinden, wobei die erste MOS-Vorrichtung (140) zwischen der zweiten Ebene von elektrischen Verbindungen (188) und der zweiten MOS-Vorrichtung (172) angeordnet ist.

13. Verfahren gemäß einem der vorhergehenden Ansprüche, wobei die dritte Schicht (108) Bereiche (108a, 108b, 108c) unterschiedlicher Dicke aufweist, derart dass, wenn das Verfahren zum Herstellen mehrerer erster MOS-Vorrichtungen (140) und mehrerer zweiter MOS-Vorrichtungen (172) durchgeführt wird, die Abstände zwischen den aktiven Bereichen einer ersten (140) und einer zweiten (172) MOS-Vorrichtung, die übereinander angeordnet sind, den verschiedenen Dicken der dritten Schicht (108) entsprechen.

14. Verfahren gemäß Anspruch 13, wobei die dritte Schicht (108), die Bereiche (108a, 108b, 108c) unterschiedlicher Dicke umfasst, durch Ausführen mehrerer aufeinanderfolgender Epitaxie Schritte (108a, 108b, 108c) des Materials der dritten Schicht (108) auf der zweiten Halbleiterschicht (106) erhalten wird, während deren Masken (202a, 202b) auf den epitaxischen Schichten (108a, 108b) gebildet werden, um die Bereiche mit unterschiedlicher Dicke der dritten Schicht (108) zu bilden.

15. Verfahren gemäß einem der vorhergehenden Ansprüche, in dem, wenn die erste MOS-Vorrichtung (140) vom Typ PMOS ist, die Herstellung der ersten PMOS-Vorrichtung (140) die Implementierung einer Epitaxie (304) von SiGe auf dem Teil (120) der ersten Halbleiterschicht (110) umfasst, die dazu bestimmt ist, den aktiven Bereich der ersten PMOS-Vorrichtung (140) zu bilden, und/oder, wenn die zweite MOS-Vorrichtung (172) vom Typ PMOS ist, die Herstellung der zweiten PMOS-Vorrichtung (172) die Verwendung einer Epitaxie (352) von SiGe auf dem Teil (152) der zweiten Halbleiterschicht (106) beinhaltet, der dazu bestimmt ist, den aktiven Bereich der zweiten PMOS-Vorrichtung (172) zu bilden.

## Claims

1. Method of producing an integrated electronic circuit (100-600) comprising at least the steps of:
- producing a substrate comprising at least a first (110) and second (106) layer of semiconductor between which at least a third layer of material (108) is placed, then
- producing at least a first MOS device (140), an active area of which is formed in at least part (120) of the first layer of semiconductor (110), then
- producing at least a second MOS device (172), an active area of which is formed in at least part (152) of the second layer of semiconductor (106), the active area of the second MOS device (172) being placed between a gate (162) of the second MOS device (172) and the active area of the first MOS device (140).

2. Method according to claim 1, in which the first layer of semiconductor (110), the second layer of semiconductor (106) and the third layer of material (108) comprise monocrystalline semiconductors produced by epitaxy.

3. Method according to one of the preceding claims, in which the third layer (108) is composed of at least SiGe or porous silicon.

4. Method according to one of the preceding claims, in which, when the first MOS device (140) is produced, the first layer of semiconductor (110) and the third layer (108) are etched according to a same pattern corresponding to the active area of the first MOS device (140).

5. Method according to one of the preceding claims, in which, when the first MOS device (140) is produced, the first (110) and second (106) layers of semiconductor and the third layer (108) are etched according to a same pattern corresponding to the active areas of the first (140) and second (172) MOS devices.

6. Method according to one of claims 4 or 5, also comprising, when the second MOS device (172) is produced, implementation of the steps of:
- removal of a remaining portion (118) of the third layer (108) etched according to the pattern corresponding to the active area of the first MOS device (140),
- deposition of a dielectric material (158) at least between the active areas of the first (140) and second (172) MOS devices.

7. Method according to one of claims 4 or 5, also comprising, when the second MOS device (172) is produced, implementation of the steps of:
- removal of a remaining portion (118) of the third layer (108) etched according to the pattern corresponding to the active area of the first MOS device (140),
- production, between the active areas of the first (140) and second (172) MOS devices, of a stack comprising a portion of electrically conductive material (610) placed between two portions of dielectric material (604).

8. Method according one of the preceding claims, in which the MOS devices (140, 172) are transistors.

9. Method according to one of claims 4 or 5, also comprising, when the second MOS device (172) is produced, implementation of the steps of:
- removal of a remaining portion (118) of the third layer (108) etched according to the pattern corresponding to the active area of the first MOS device (140),
- production, between the active areas of the first (140) and second (172) MOS devices, of a memory stack (408) comprising a portion of material (406) able to effect a retention of electrical charges placed between two portions of dielectric material (404),
the first (140) and second (172) MOS devices forming a memory cell.

10. Method according to one of the preceding claims, also comprising, between the steps of producing the first (140) and second (172) MOS devices, the steps of:
- deposition of a dielectric material (142) covering at least the first MOS device (140),
- securing of said dielectric material (142) against a second substrate (144).

11. Method according to claim 10, also comprising, after the production of the second MOS device (172), the steps of:
- deposition of a dielectric material (182) covering the second MOS device (172),
- production, at least in the dielectric material (182) covering the second MOS device (172), of at least a first level of electrical connections (176, 178) and one or more vias (174, 180) electrically connecting the second MOS device (172) to the first electrical connection level (176, 178), the second MOS device (172) being placed between the first electrical connection level (176, 178) and the first MOS device (140).

12. Method according to claim 11, also comprising, after the production of the first electrical connection level (176, 178), the steps of:
- securing of the dielectric material (182) covering the second MOS device (172) against a third substrate (184),
- removal of the second substrate (144),
- production, at least in a dielectric material (187) covering the first MOS device (140), of at least a second electrical connection level (188) and one or more vias electrically connecting the first MOS device (140) to the second electrical connection level (188), the first MOS device (140) being placed between the second electrical connection level (188) and the second MOS device (172).

13. Method according to one of the preceding claims, in which the third layer (108) comprises regions (108a, 108b, 108c) with different thicknesses such that, when the method comprises the production of several first MOS devices (140) and several second MOS devices (172), the distances between the active areas of a first (140) and second (172) MOS device produced one above the other correspond to the various thicknesses of the third layer (108).

14. Method according to claim 13, in which the third layer (108) that comprises regions (108a, 108b, 108c) of different thicknesses is obtained by performing several successive steps (108a, 108b, 108c) of epitaxy of the material of the third layer (108) on the second layer of semiconductor (106) during which masks (202a, 202b) are produced on the epitaxially grown layers (108a, 108b) in order to form the regions of different thicknesses of the third layer (108).

15. Method according to one of the preceding claims, in which, when the first (140) MOS device is of the PMOS type, production of the first (140) PMOS device comprises the implementation of an epitaxial growth of SiGe (304) on the part (120) of the first (110) layer of semiconductor intended to form the active area of the first PMOS device (140), and/or, when the second MOS device (172) is of the PMOS type, the production of the second PMOS device (172) comprises the implementation of an epitaxial growth of SiGe (352) on the part (152) of the second layer of semiconductor (106) intended to form the active area of the second PMOS device (172).
